# EUROPÄISCHE PATENTSCHRIFT

(11) **EP 0 913 730 B1**
(45) Veröffentlichungstag und Bekanntmachung des Hinweises auf die Patenterteilung: **25.07.2007**
(21) Anmeldenummer: 97119181.2
(22) Anmeldetag: 03.11.1997
(51) Int. Cl.: G03F 1/00, G03F 7/12, G03F 7/095, G03F 7/09

(54) **Verfahren zum Herstellen einer Druckform**
Process for making a printing form
Procédé pour fabriquer un cliché d'impression

(43) Veröffentlichungstag der Anmeldung: 06.05.1999
(73) Patentinhaber: Stork Prints Austria GmbH, 6336 Langkampfen (AT)
(72) Erfinder: Rückl, Siegfried, A-6330 Kufstein (AT)
(74) Vertreter: TER MEER - STEINMEISTER & PARTNER GbR

(56) Entgegenhaltungen:
- EP-A- 0 001 030
- EP-A- 0 065 760
- EP-A- 0 264 845
- EP-A- 0 785 474
- EP-A- 0 803 772
- DE-A- 4 203 554
- DE-A- 4 243 750
- DE-A- 4 339 010
- DE-A- 19 536 805
- DE-A- 19 536 806
- US-A- 5 024 919

## Beschreibung

Die Erfindung betrifft ein Verfahren zum Herstellen einer Druckform.

Bei der Herstellung von Siebdruckschablonen ist es bekannt, auf ein als Träger der Druckform oder -schablone dienendes Sieb einen photoempfindlichen Lack aufzutragen, zu belichten und anschließend zu entwickeln, um die Photolackschicht in Bereichen, in denen später beim Drucken Farbe durch das Sieb übertragen werden soll, zu entfernen. Die musterbedingte Belichtung der Photolackschicht erfolgt dabei beispielsweise durch einen auf den Rohling der Druckform aufgelegten Großfilm oder punktweise mit Hilfe von Laserlicht, wobei die gesamte Photolackschicht punktweise abgetastet und nur an den Stellen belichtet wird, an denen die chemische Struktur des Photolacks für die spätere Entwicklung musterbedingt verändert werden soll. Ferner ist es bekannt, die Photolackschicht mit einem CO₂-Laser mustergemäß abzudampfen.

Sowohl die Verwendung von Großfilmen als auch der Einsatz von Lasern, insbesondere von CO₂-Lasern, die einen sehr hohen Energieverbrauch aufweisen, verteuert die Herstellung von Siebdruckschablonen.

Bei der Herstellung einer einer Flexodruckform, wird ein strahlungs- oder photoempfindliches Material, beispielsweise ein Photopolymer oder Photoelastomer zunächst auf einen Träger aufgebracht. Dann wird durch musterbedingtes Bestrahlen oder Belichten einzelner Bereiche der Schicht wird das Polymer vernetzt. Für die Belichtung wird vorzugsweise ultraviolette Strahlung verwendet. Anschließend werden in einem geeigneten Entwickler die nichtbelichteten und damit nichtvernetzten Polymerbereiche ausgewaschen. Gegebenenfalls wird mit einer im UV-Bereich emittierenden Strahlungsquelle die Photopolymerschicht nachbelichtet und dadurch intensiver vernetzt.

Bei den bisher bekannten Verfahren werden die mustergemäß nicht zu belichtenden Bereiche der strahlungsempfindlichen Schicht, also insbesondere der Photoelastomerschicht, entweder wie bei Siebdruckschablonen durch einen Ganzfilm oder durch eine mittels Düsen musterförmig aufgespritzte Schicht abgedeckt.

Bei der Abdeckung der strahlungsempfindlichen Schicht durch einen photographisch hergestellten Ganzfilm ist bei zylindrischen Druckformen eine Nahtstelle im Muster meistens nicht zu vermeiden. Auf jeden Fall verteuert ein derartiger Ganzfilm, der die Größe der Druckform und bei zylindrischen Druckformen also die Größe der Zylinderoberfläche aufweisen muß, die Herstellung von Druckformen erheblich.

Das mustergemäße Aufspritzen einer abdeckenden, lichtabsorbierenden und/oder lichtreflektierenden Farbschicht mit Hilfe von Düsen auf eine strahlungsempfindliche Schicht verlangt nach hochreinen Abdecktinten, die hinreichend auf der strahlungsempfindlichen Schicht haften und trotzdem die verwendeten Düsen nicht verstopfen. Neben den hohen Anforderungen an die Abdecktinten müssen auch die zum Aufspritzen verwendeten Düsen hohe Anforderungen erfüllen, da je Zeiteinheit viele Tropfen mit gleichbleibender Größe zu erzeugen sind.

Durch das mustergemäße Aufspritzen von Abdecktinte auf die Oberfläche einer Druckform, insbesondere auf eine Zylinderoberfläche, lassen sich zwar die Probleme, die bei der Handhabung von Großfilmen auftreten vermeiden, jedoch erfordert die Aufspritztechnik sehr präzise Düsen, die aufwendig herzustellen und zu steuern sind.

Die DE 195 36 806 beschreibt ein Verfahren zum Herstellen von photopolymeren Tiefdruckplatten, bei dem auf einen dimensionsstabilen Träger zunächst eine durch aktinische Strahlung, also durch UV-Strahlung vernetzbare Schicht, dann eine Trennschicht und darauf eine gegen IR-Strahlung empfindliche Schicht aufgebracht werden. Die Trennschicht, die als Diffusionssperrschicht zwischen den strahlungsempfindlichen Schichten dient, ist hierbei UV-durchlässig.

Aus der EP 0 785 474 A ist ein Verfahren zur Herstellung einer Flexodruckschablone bekannt, bei dem auf eine vergleichsweises dicke Photoelastomerschicht, die auf der Oberfläche eines Trägers angeordnet ist, eine vergleichsweise dünne lichtempfindliche Schicht aufgetragen wird. Durch punktweises Belichten der dünnen lichtempfindlichen Schicht und anschließendes Entwickeln wird unmittelbar auf der Photoelastomerschicht eine Belichtungsmaske für die darunter liegende dicke Photoelastomerschicht ausgebildet.

Die DE 42 03 554 A1 beschreibt ein Verfahren zum filmlosen Herstellen von flexiblen Druckformen, bei dem eine lichtempfindliche Aufzeichnungsschicht, die auf einem formstabilen Träger angeordnet ist, mit einer eingefärbten Deckfolie abgedeckt wird. Die Deckfolie, die UV-Licht absorbiert, wird zur Herstellung einer Bestrahlungsmaske zunächst bildmäßig geschnitten, um anschließend die ausgeschnittenen Bildstellen der eingefärbten Deckfolie abzuziehen.

Die Druckschrift US 5 024 919 betrifft ein Verfahren zum Herstellen von feinen Strukturen auf Halbleitern. Dabei wird zum Herstellen einer Ätzmaske auf einer Halbleiteroberfläche mit relativ großen Höhenunterschieden zunächst ein erstes für fernes UV-Licht empfindliches Positivresist als Einebnungsschicht aufgebracht, um darauf unmittelbar ein für UV-Licht empfindliches Positivresist aufzutragen. Hierbei bildet sich eine Zwischenflächenschicht. Die so erhaltende Resiststruktur wird zunächst mit Hilfe einer Maske mit UV-Licht belichtet und anschließend entwickelt. Nach dem Entwickeln wird die Zwischenflächenschicht entfernt, um dann mit fernem UV-Licht zu belichten. Anschließend werden die belichteten Bereiche entfernt, um die gewünschte Ätzmaske zu erhalten.

Aus der US 5 024 919 ist weiter ein Verfahren zur Herstellung einer Ätzmaske oder dergleichen bekannt, bei dem zwischen einer unteren Resistschicht und einer oberen Resistschicht eine Zwischenschicht vorgesehen ist. Die Zwischenschicht ist dabei zumindest für die Strahlung transparent, für die die untere Resistschicht empfindlich ist. Die obere Resistschicht besteht dabei aus einem Material, das zunächst für fernes UV-Licht durchlässig ist, und das durch Belichten mit UV-Licht für fernes UV-Licht undurchlässig wird, so daß ein Entwicklungsschritt vor dem großflächigen Belichten mit fernem UV-Licht nicht erforderlich ist.

Die EP 00 65 760 A2 beschreibt ein Verfahren, bei dem auf eine photoempfindliche Schicht auf einem Träger eine Tonerschicht bzw. undurchsichtige Bereiche als Photomaske aufgebracht werden. Dabei kann zwischen der Tonerschicht und der photoempfindlichen Schicht eine transparente Deckschicht vorgesehen sein, mit deren Hilfe die Tonerschicht vor dem Entwickeln der belichteten photoempfindlichen Schicht entfernt wird.

Die DE 43 39 010 A1 betrifft Druckplatten, auf die das Bild mit einem Laser übertragbar ist. Zur Herstellung dieser Druckplatten wird auf eine für UV-Licht empfindliche Photopolymerschicht ein dünner Polymerfilm laminiert, der mit einem UV-Absorber dotiert ist. Zur Herstellung einer Belichtungsmaske wird der für UV-Licht undurchlässige Polymerfilm mit Hilfe eines Lasers, der bei einer ausgewählten Wellenlänge arbeitet, von dem Photopolymer abgeschmolzen. Anschließend kann dann die Photopolymerschicht in üblicher Weise mit UV-Flutlicht belichtet und anschließend entwickelt werden.

Auch die DE 195 36 805 A1 zeigt ein Verfahren zur Herstellung von Flexodruckplatten mit einer unteren UV-empfindlichen Schicht und einer oberen IR-empfindlichen Schicht, die ohne Zwischenschicht auf einem Träger ausgebildet sind.

Die DE 42 43 750 A1 beschreibt ein weiteres Verfahren zur Herstellung einer Druckform, bei dem eine Photopolymerschicht, die für UV-Licht empfindlich ist, mit einer weiteren strahlungsempfindlichen Beschichtung überzogen wird, die entweder zunächst strahlungsdurchlässig oder strahlungsundurchlässig ist, um durch Bestrahlung stahlungsundurchlässig bzw. strahlungdurchlässig für UV-Strahlung gemacht zu werden.

Davon ausgehend liegt der Erfindung die Aufgabe zugrunde, ein weiteres Verfahren zum Herstellen einer Druckform bereitzustellen, das einfach und kostengünstig auszuführen ist und dabei mustergetreue Druckformen liefert.

Diese Aufgabe wird durch das Verfahren nach Anspruch 1 gelöst. Vorteilhafte Ausgestaltungen und Weiterbildungen des erfindungsgemäßen Verfahrens sind in den Unteransprüchen beschrieben.

Erfindungsgemäß wird also bei der Herstellung von Druckform, insbesondere bei der Herstellung von zylindrischen Flexodruckformen, auf eine strahlungsempfindliche Schicht, insbesondere eine Photopolymer- oder Photoelastomerschicht eine strahlungs- bzw. lichtdichte Abdeckschicht aufgetragen. Durch eine anschließende Strukturierung der Abdeckschicht entsprechend einem Muster mittels einer Strukturierungsmaske wird eine Bestrahlungs- oder Belichtungsmaske unmittelbar auf der strahlungsempfindlichen Schicht ausgebildet. Anschließend erfolgt dann in gewohnter Weise die Belichtung und Entwicklung der strahlungsempfindlichen Schicht.

Bei dem erfindungsgemäßen Verfahren wird also die mustergemäße Belichtungsmaske unmittelbar auf der zu belichtenden Schicht ausgebildet, wobei zunächst die zu belichtende Schicht vollständig mit der Abdeckschicht abgedeckt wird, um diese dann zu strukturieren. Bei der Auswahl des Abdeckschichtmaterials brauchen daher nur die Hafteigenschaften sowie die Strahlungsabsorbtions- und -reflektionseigenschaften berücksichtigt zu werden. Die Absorbtions- und/oder Reflektionsfähigkeit der Abdeckschicht ist dabei auf die Strahlungsempfindlichkeit der ersten strahlungsempfindlichen Schicht abzustimmen. Obwohl es ausreicht, wenn die Abdeckschicht nur die zum Belichten der ersten strahlungsempfindlichen Schicht verwendete Strahlung vollständig abblockt, ist es vorteilhaft, wenn sie auch in den benachbarten Strahlungsbereichen ein gutes Absorbtions- bzw. Reflektionsvermögen aufweist.

Das erfindungsgemäße Verfahren läßt sich nicht nur bei der eigentlichen Herstellung von Druckformen einsetzen, bei dem die erste strahlungsempflindliche Schicht entsprechend einem späteren zu druckenden Muster strukturiert wird, sondern auch bei der Herstellung von galvanoplastisch geformten Sieben. Hierbei wird dann die erste strahlungsempfindliche Schicht, die auf einer vollflächigen, leitenden, insbesondere metallischen Oberfläche angeordnet ist, entsprechend dem galvanisch herzustellenden Sieb gemustert.

Das erfindungsgemäße Verfahren läßt sich weiter vereinfachen, wenn vorgesehen wird, daß die mustergemäß strukturierte Abdeckschicht, also die Bestrahlungsmaske beim Entwickeln der ersten strahlungsempfindlichen Schicht entfernt wird wobei mechanische und/oder chemische Mittel eingesetzt werden. Hierdurch wird ein zusätzlicher das Verfahren unnötig komplizierender Bearbeitungsschritt zum separaten Entfernen der Abdeckschicht nach dem Belichten vermieden.

Bei einer Ausgestaltung der Erfindung ist vorgesehen, daß auf die Abdeckschicht eine Strukturierungsmaske mustergemäß aufgetragen, vorzugsweise aufgespritzt, insbesondere punktweise aufgespritzt wird, und daß die nichtabgedeckten Teile der Abdeckschicht entfernt werden, wobei die Strukturierungsmaske (6) mittels einer Wachslösung gebildet wird und die nichtabgedeckten Teile der Abdeckschicht chemisch entfernt, vorzugsweise weggeätzt werden.

Das Aufspritzen einer Abdeckflüssigkeit, insbesondere einer Wachslösung, auf die zur Bildung einer Bestrahlungsmaske vorgesehene Abdeckschicht hat den Vorteil, daß die aufzuspritzende Flüssigkeit, also beispielsweise die Wachslösung nur im Hinblick auf ihre spätere Funktion als Strukturierungsmaske, auf ihre Haftfähigkeit und Aufspritzbarkeit mittels Düsen ausgewählt werden kann. Lichtabschirmeigenschaften braucht diese Flüssigkeit nicht zu besitzen, so daß ihr auch keine Pigmente oder lichtreflektierende oder-absorbierende Partikel, die insbesondere das Aufspritzen der Flüssigkeit mittels Düsen beeinträchtigen können, enthalten muß.

Bei einer besonders vorteilhaften Ausgestaltung der Erfindung ist vorgesehen, daß zur Strukturierung der Abdeckschicht eine zweite strahlungsempfindliche Schicht auf die Abdeckschicht aufgetragen, mustergemäß bestrahlt und entwickelt wird und daß die nichtabgedeckten Teile der Abdeckschicht entfernt werden, wobei zweckmäßigerweise die zu entfernenden Teile der Abdeckschicht beim Entwickeln der zweiten strahlungsempfindlichen Schicht entfernt werden.

Hierdurch wird es ermöglicht, das gewünschte Muster zunächst durch einen sehr genauen Belichtungsprozeß auf die zweite strahlungsempfindliche Schicht zu übertragen, und dann in einem Arbeitsgang beim Entwickeln der strahlungsempfindlichen Schicht auch die Abdeckschicht musterbedingt zu entfernen und somit zu strukturieren.

Zweckmäßigerweise ist der Strahlungsempfindlichkeitsbereich der zweiten strahlungsempfindlichen Schicht von dem der ersten strahlungsempfindlichen Schicht verschieden. Durch die Verwendung von photoempfindlichen Materialien mit unterschiedlichen Empfindlichkeitsbereichen wird es ermöglicht, auch Abdeckschichten zu verwenden, deren Absorbtions- und Reflektionsvermögen für die bei der Belichtung der zweiten strahlungsempfindlichen Schicht verwendete Strahlung relativ schlecht ist, da diese Strahlung die erste photoempfindliche Schicht nicht vernetzen kann.

Durch die Verwendung eines Photolacks, der auch für sichtbares Licht strahlungsempfindlich ist, für die zweite strahlungsempfindliche Schicht wird es ermöglicht, eine für die Belichtung geeignete Lichtquelle aus einer Vielzahl von in diesem Wellenlängenbereich zur Verfügung stehenden Lichtquellen auszuwählen. Insbesondere sind in diesem Bereich auch Laserlichtquellen verfügbar, mit denen sich eine besonders präzise und mustergetreue Belichtung erreichen läßt.

Bei der Verwendung von Photolacken können sowohl sogenannte Negativlacke, bei denen der Lack durch die Bestrahlung vernetzt und damit gehärtet wird, als auch Positivlacke eingesetzt werden, bei denen der ansich harte Photolack durch die Belichtung zersetzbar ist. Besonders vorteilhaft ist es jedoch, einen Positivlack zu verwenden, der durch Licht zersetzbar ist, da hier sowohl die erste Belichtung also die Belichtung der zweiten photoempfindlichen Schicht als auch die zweite Belichtung, also die Belichtung der ersten strahlungsempfindlichen Schicht in denselben musterbedingten Bereichen erfolgt. Hierdurch wird es ermöglicht, auch relativ einfache Abdeckschichten zu verwenden, die die bei der Belichtung der ersten strahlungsempfindlichen Schicht verwendete Strahlung nur unvollkommen abblocken, da in diesem Fall eine Vorbelichtung der ersten strahlungsempfindlichen Schicht beim Belichten der zweiten strahlungsempfindlichen Schicht die Ausbildung des Musters kaum stört, sondern eher fördert.

Zweckmäßigerweise ist vorgesehen, daß die zweite strahlungsempfindliche Schicht 1 µm bis 20 µm, vorzugsweise 7 µm bis 14 µm, insbesondere 10 µm dick ist.

Es ist jedoch besonders vorteilhaft, wenn auch die bei der Bestrahlung oder Belichtung der zweiten strahlungsempfindlichen Schicht verwendete Strahlung von der Abdeckschicht nicht durchgelassen wird, da somit eine vorzeitige, unerwünschte Vernetzung der ersten strahlungsempfindlichen Schicht während dem Belichten der zweiten strahlungsempfindlichen Schicht verhindert wird.

Eine besonders mustergetreue Druckform oder Galvanisierform für Trägersiebe wird erhalten, wenn vorgesehen ist, daß die mustergemäße Bestrahlung der Abdeckschicht bzw. der zweiten strahlungsempfindlichen Schicht punkweise erfolgt. Hierbei läßt sich die Zeit für die erste Belichtung, also für die Belichtung der zweiten strahlungsempfindlichen Schicht deutlich verkürzen, wenn bei der punkweisen Bestrahlung mehrere nebeneinander liegende Musterpunkte mittels einer entsprechenden Anzahl von Bestrahlungspunkten gleichzeitig mustergemäß bestrahlt werden.

Besonders gute Abschirmeigenschaften werden erreicht, wenn die Abdeckschicht feine lichtabsorbierende und/oder lichtreflektierende Partikel, insbesondere Ruß (Black Carbon) oder feine Metallpartikel, Pigmente und/oder strahlungsabsorbierende Chemikalien enthält. Zweckmäßigerweise kann dabei vorgesehen sein, daß die strahlungsabsorbierenden Chemikalien oder Pigmente einer Wachslösung zugesetzt sind, die zur Ausbildung der Abdeckschicht auf die erste strahlungsempfindliche Schicht aufgetragen wird.

Eine andere vorteilhafte Möglichkeit besteht darin, daß die feinen lichtabsorbierenden oder lichtreflektierenden Partikel in Gelatine oder Polyvinylalkohol suspendiert sind.

Wenn die Abdeckschicht als lichtabsorbierende und -reflektierende Mittel feine Metallpartikel enthalten soll, ist es zweckmäßig, wenn die Suspension von feinen Metallpartikeln in Gelatine durch Reduktion von in Gelatine gelösten Metallsalzen, insbesondere Silberhalogeniden, hergestellt wird. Hierdurch wird die Arbeitssicherheit bei dem erfindungsgemäßen Verfahren deutlich verbessert, da sehr feine Metallpartikel leicht entzündlich und hochexplosiv sind.

Besonders einfach läßt sich die Abdeckschicht mit einem Tauchbeschichtungsverfahren auftragen, insbesondere wenn die gewünschte Abdeckschicht 1 µm bis 20 µm, vorzugsweise 7 µm bis 14 µm, insbesondere 10 µm dick sein soll.

Wird ist das erfindungsgemäße Verfahren zur Herstellung von Flexodruckformen eingesetzt, so ist vorgesehen, daß bei denen die erste strahlungsempfindliche Schicht eine Photopolymerschicht, insbesondere eine Photoelastomerschicht, mit einer Dicke von 1 mm bis 10 mm, vorzugsweise von 2 mm bis 5 mm ist.

Insbesondere bei der Herstellung von Siebdruckschablonen oder Matrizen zur galvanischen Herstellung von Trägersieben ist es zweckmäßig, wenn die erste strahlungsempfindliche Schicht eine Photolackschicht ist, die vorzugsweise mit einem Tauchbeschichtungsverfahren auf den Träger aufgebracht wird. Zweckmäßigerweise lassen sich dabei sowohl Photolacke auf der Basis von Gelatine oder Polyvinylalkohol als auch Photolacke auf Kunstharzbasis einsetzen. Um eine Rissbildung beim Trocknen oder Aushärten der Photolacke oder bei der späteren Benutzung der fertigen Druckform zu verhindern, ist erfindungsgemäß vorgesehen, daß der Photolackschicht Stoffe zum Vergrößern ihrer Elastizität beigefügt sind. Insbesondere bei der Verwendung von Fotolacken auf Gelatine- oder Polyvinylalkohol können dem Photolack Weichermacher, z. B. Glyzerin oder Glykol, beigemengt sein.

Für die Herstellung von Flexodruckformen ist es vorteilhaft, wenn derTräger eine vollflächige, geschlossene Oberfläche aufweist, auf der die erste strahlungsempfindliche Schicht aufgebracht ist.

Für flache oder ebene Siebdruckschablonen ist es zweckmäßig, wenn der Träger aus einem Textilgewebe, insbesondere aus einem Seidengasegewebe, gebildet ist, das vorzugsweise durch eine chemische und/oder galvanische Metallabscheidung verstärkt ist. Durch die Metallabscheidung wird das besonders feine Gewebe nicht nur mechanisch verstärkt, sondern es wird auch dessen Reflexionsfähigkeit für Strahlung verbessert, so daß das Siebgewebe beim Abtragen der Abdeckschicht und der Belichtung der ersten strahlungsempfindlichen Schicht nicht beschädigt wird, wenn die hierfür jeweils verwendete Strahlung etwas zu hoch dosiert ist.

Die Erfindung wird im folgenden beispielsweise anhand der Zeichnung näher erläutert. Es zeigen:
**Fig.1** einen achsparallelen Längsschnitt durch einen zylindrischen Rohling zur Herstellung einer Druckform gemäß einem Ausführungsbeispiel der Erfindung.
**Fig.2** eine Schnittdarstellung entsprechend Fig. 1 des Rohlings nach einer ersten Belichtung und Entwicklung,
**Fig.3** eine Schnittdarstellung des Rohlings nach Fig.2 bei einer zweiten Belichtung,
**Fig.4** eine Schnittdarstellung der fertiggestellten zylindrischen Druckform nach der letzten Entwicklung,
**Fig.5** eine Vorrichtung zur mustergemäßen Belichtung eines Rohlings für eine Druckform,
**Fig.6 eine** Vorrichtung zur Entwicklung des Rohlings nach der ersten Belichtung.
**Fig.7** eine Vorrichtung zur großflächigen Belichtung des Rohlings,
**Fig.8** eine Vorrichtung zur Entwicklung des Rohlings nach der großflächigen Belichtung,
**Fig.9** einen achsparallelen Längsschnitt durch einen zylindrischen Rohling zur Herstellung einer Siebdruckschablone gemäß einem nicht erfindungsgemäßen Beispiel.
**Fig.10** eine vergrößerte Schnittdarstellung des beschichteten Siebs aus Figur 1,
**Fig.11** eine vergrößerte Schnittdarstellung eines Siebs mit einer anderen Beschichtung,
**Fig.12** eine Darstellung des Siebs gemäß Figur 2 bei einem nicht erfindungsgemäßen Abtragen einer Abdeckschicht zur Strukturierung einer Bestrahlungsmaske,
**Fig.13** eine Schnittdarstellung des Rohlings nach Figur 9 während einer Belichtung,
**Fig.14** eine vergrößerte Schnittdarstellung des fertigen Siebs nach der Entwicklung,
**Fig.15** eine Vorrichtung zu einem nicht erfindungsgemäßen, mustergemäßen Abtragen der Abdeckschicht auf einem zylindrischen Rohling,
**Fig.16** eine Vorrichtung zur großflächigen Belichtung des Rohlings und
**Fig.17** eine Vorrichtung zur Entwicklung des Rohlings nach der Belichtung.

In den verschiedenen Figuren der Zeichnung sind einander entsprechende Teile mit gleichen Bezugszeichen versehen.

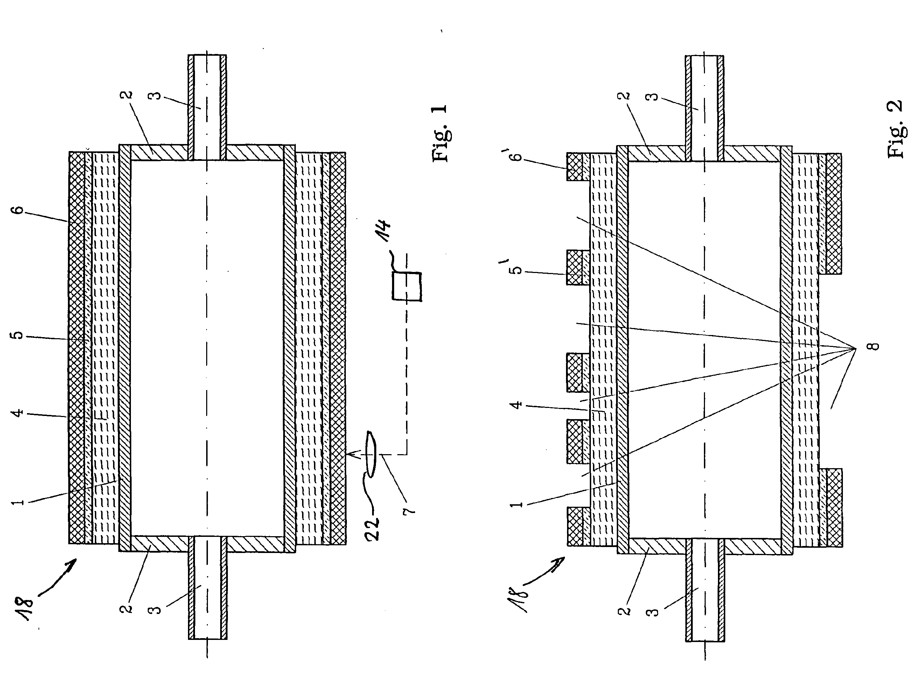

Ein in Fig.1 gezeigter Rohling für eine Druckform, der im folgenden unabhängig von der Herstellungsstufe der Einfachheit halber als Druckform 18 bezeichnet wird, weist ein Trägerrohr 1 auf, an dessen Stirnseiten Deckplatten 2 und Achsstummel 3 eingeschweißt oder eingeklebt sind. Die Achsstummel 3 dienen dabei zur späteren Einspannung der Druckform 18 auf einer Druckmaschine.

Auf dem Trägerrohr 1 ist eine erste strahlungsempfindliche Schicht, insbesondere eine Photopolymerschicht, vorzugsweise eine Photoelastomerschicht 4 mit einer Dicke von vorzugsweise 2 bis 5 mm aufgebracht. Im allgemeinen wird diese Photoelastomerschicht 4 aus einer Photoelastomerplatte, z.B. Nyloprint, aufgebaut, die um das Trägerrohr 1 gewickelt wird. Das Photoelastomer dieser Platte weist zunächst nur einen niedrigen Polymerisationsgrad auf und ist daher sowohl elastisch als auch plastisch verformbar und verklebt bei Wärmeeinwirkung mit dem Trägerrohr 1 und an der Stoßstelle mit sich selbst bei Temperaturen von etwa 120°C. Hierbei erfolgt noch keine Vernetzungsreaktion, so daß die Strahlungs- oder Lichtempfindlichkeit der auf dem Trägerrohr 1 aufgebrachten Photoelastomerschicht 4 nicht beeinträchtigt wird.

Anstelle der mit 2 bis 5 mm relativ dicken Photoelastomerschicht 4, wie sie für Flexodruckformen eingesetzt wird, kann auch als erste strahlungsempfindliche Schicht beispielsweise eine dünne Photolackschicht oder dergleichen vorgesehen werden, wenn eine Siebdruckform mit dem erfindungsgemäßen Verfahren hergestellt werden soll. Dabei ist anstelle des Trägerrohrs 1 dann ein entsprechender Siebzylinder vorzusehen.

Auf die Photoelastomerschicht 4 wird nun eine Abdeckschicht 5 z.B. mittels Tauchbeschichtung aufgetragen. Dabei wird beispielsweise eine wässrige Lösung von Gelatine oder Polyvinylalkohol aufgebracht, der etwa 10 Gew.-% Ruß (Black Carbon) beigefügt ist. Es kann aber auch eine Gelatine verwendet werden, in der feinste Metallpartikel suspendiert sind. Da derartig kleine Metallpartikel hochexplosiv sind, kann die Suspension durch eine Reduktion von in Gelatine gelösten Metallsalzen, z.B. Silberhalogeniden, hergestellt werden. Die die auf diese Weise erzeugten feinsten Metallpartikel umgebende Gelatine verhindert dann deren Oxidation und somit eine Explosion.

Bei der Tauchbeschichtung zum Auftragen der Abdeckschicht 5 wird über die mit senkrechter Achse angeordnete Druckform 18 eine Ringrakel (nicht dargestellt) von oben nach unten gezogen, wobei sich erwärmte Gelatinelösung im Ringraum zwischen der Ringrakel und der Photopolymerschicht 4 befindet und bei der Abwärtsbewegung als dünner Film auf der Oberfläche der Photopolymerschicht 4 haften bleibt. Die Dicke dieses Films kann durch die Temperatur der Gelatinelösung, durch den Feststoffanteil, also durch den Anteil von Ruß oder Metallpartikel in der Gelatinelösung, die Intensität einer gegebenenfalls gleichzeitig erfolgenden Kühlung durch einen Kaltluftstrom und die Geschwindigkeit der Abwärtsbewegung variiert werden.

Bei der rasch erfolgenden Abkühlung des Gelatine- oder Polyvinylalkoholfilms erstarrt dieser und wird in einem nachfolgenden Zwischentrocknungsvorgang von seinem Wasseranteil befreit. Durch den Zusatz von geringen Anteilen von Weichmachern, z.B. Glyzerin oder Glykol, kann der Gelatine- oder Polyvinylalkoholfilm auch nach der Trocknung soweit elastisch gehalten werden, so daß Rißbildungen in der trocknenden Schicht, also in der sich bildenden Abdeckschicht 5 verhindert werden können. Sofern erforderlich kann auch eine Gerbung der Abdeckschicht 5 durch Besprühen mit Formaldehyd oder Alaunlösung erfolgen. Hierbei ist jedoch zu berücksichtigen, daß sich die Abdeckschicht 5 in einem späteren Verfahrensschritt leichter bzw. schneller entfernen läßt, wenn die Gelatine oder Polyvinylalkohol nicht gegerbt wird.

Für die Herstellung der Abdeckschicht 5 kann auch eine Wachslösung verwendet werden, der die gleichen oder ähnliche UV-absorbierende oder UVreflektierende Chemikalien oder Pigmente zugesetzt sind, um die natürliche UV-Absorbtion der Wachse zu erhöhen. Neben Ruß (Black Carbon) kommen als solche Derivate des Benzophenons in Betracht, insbesondere wenn sich dessen Substituenten wie Hydroxy- und/oder Alkoxy-Gruppen in 2- und/oder 4-Stellung befinden. Weiter sind auch substituierte Benzotriazole geeignet und ferner Phenyl-substituierte Acrylate (Zimtsäuere-Derivate), die gegebenenfalls Cyano-Gruppen in 2-Stellung besitzen. Schließlich kommen auch Salicylate, organische Nickel-Komplexe oder Naturstoffe wie Umbeliferon oder Urocansäuere in Frage.

Für die Abdeckschicht 5 lassen sich aber auch Kunstharze, insbesondere Kunstharze, vorzugsweise Epoxyharz, Polyesterharz oder Methylmethacrylatharz einsetzen, dem ebenfalls die Lichtabschirmfähigkeit erhöhende Stoffe zugefügt sind. Um eine Rißbildung beim Vernetzen der Harze zu verhindern, werden diesen Komponenten zugesetzt, die eine größere Elastizität aufweisen. Ferner kann die Abdeckschicht auch aus einem Thermoplast, etwa Polyäthylen, bestehen.

Nach dem Ausbilden der Abdeckschicht 5 wird als dritte Schicht eine zweite strahlungsempfindliche Schicht, insbesondere eine photoempfindliche Schicht, vorzugsweise eine Photolackschicht 6 aufgetragen. Als Photolack für die Photolackschicht 6 kann dabei entweder ein lichthärtbarer oder ein durch Licht zersetzbarer Photolack verwendet werden. Das Aufbringen der Photolackschicht 6 erfolgt dabei zweckmäßigerweise ebenfalls im Tauchbeschichtungsverfahren. Der Photolack für die Photolackschicht 6 liegt meist in alkoholischer oder ketonischer Lösung vor. Diese Lösungsmittel quellen eine Gelatineschicht nicht an. Es können aber auch wässrige Emulsionen von Photolacken verwendet werden, wenn nach dem Kontakt der Abdeckschicht 5 mit der Photolackemulsion bis zur erfolgten Trocknung der Photolackschicht 6 jede weitere mechanische Berührung der beschichteten Druckformoberfläche vermieden wird. Diese letztgenannten Emulsionen sind besonders für das Aufbringen einer Photolackschicht 6 auf eine aus Wachs bestehende Abdeckschicht 5 geeignet, weil sie das Wachs nicht anlösen.

Nach Trocknung der Photolackschicht 6 wird diese entsprechend einem später mit der Druckform 18 zu druckendem Muster bestrahlt. Hierfür wird eine Strahlung verwendet, für die die zweite strahlungsempfindliche Schicht empfindlich ist. Bei der hier beschriebenen Photolackschicht 6 erfolgt die Bestrahlung also mit Hilfe eines Lichtstrahls, insbesondere mit Hilfe eines Laserstrahls. Je nach dem verwendeten Photolack kann als Licht für die Belichtung der Photolackschicht 6 ultraviolettes oder sichtbares Licht verwendet werden. Beispielsweise ist es möglich die Belichtung der Photolackschicht 6 mit Hilfe eines Lasers, dessen Licht im UV-Blau- oder Grünbereich liegt, insbesondere mit Hilfe eines Argon-Ionen-Lasers durchzuführen, dessen Wellenlänge mit 488 nm im sichtbaren Blaubereich liegt.

Ein Vorteil der Belichtung mit der genannten Wellenlänge ist, daß eine Vorvernetzung der unter der Photolackschicht 6 liegenden Photoelastomerschicht 4 kaum erfolgt, da für eine Vernetzung dieser Photoelastomerschicht 4 Licht mit höherer Quantenenergie und somit kürzerer Wellenlänge, also Licht des ultravioletten Spektralbereichs erforderlich ist. Um die verwendete Laserstrahlung sehr gut absorbieren zu können, kann es bei bestimmten Zusammensetzungen der Abdeckschicht erforderlich sein, daß ein weiteres Pigment zugesetzt wird.

Der Laserstrahl 7 wird an seiner Auftreffstelle auf die Photolackschicht 6 der Druckform 18 durch eine Linsenanordnung oder eine Laseroptik 22 auf einen Strahldurchmesser von etwa 20 bis 30 µm fokussiert. Die Belichtung erfolgt entsprechend dem zu druckenden Muster, das heißt der Laserstrahl 7 wird durch eine entsprechende Anordnung mit Blendenfunktion an den nicht zu belichtenden Stellen unterbrochen. Beispielsweise kann für die Unterbrechung des Laserstrahls 7 ein akustooptischer oder elektrooptischer Schalter 14 eingesetzt werden. Bei dieser Methode der optischen Steuerung des Laserstrahls 7 können pro Sekunde etwa 10⁶ Musterpunkte belichtet werden.

Nach der Belichtung wird die Photolackschicht 6 entwickelt. Bei dieser ersten Entwicklung wird, falls ein lichthärtbarer Photolack, also ein Negativlack, für die Photolackschicht 6 verwendet wurde der nichtbelichtete und somit unvernetzte Photolack ausgewaschen. Dies geschieht üblicherweise mit einem auf dem verwendeten Photolack abgestimmten Entwickler. Zweckmäßigerweise kann ein alkalischer Entwickler mit etwa 2% Soda und gegebenenfalls ebenso geringen Anteilen an Natron- oder Kalilauge verwendet werden. Bei dieser Entwicklung wird nach dem Auswaschen der unvernetzten Photolackschicht auch die dann nicht mehr abgedeckte Abdeckschicht 5 durch den alkalischen Entwickler aufgelöst und abgetragen. Die Teile der Abdeckschicht 5, die für deren Strukturierung entsprechend dem zu druckenden Muster entfernt werden müssen, werden also beim Entwickeln der Photolackschicht 6 gleich mit entfernt. Die bei der Entwicklung nicht abgetragenen Teile der Photolackschicht 6 schützen somit die nicht abzutragenden Teile der Abdeckschicht 5 und dienen damit als Strukturierungsmaske 6' für die Abdeckschicht 5.

Bei der Verwendung von lichthärtenden Photolacken, die nicht mit alkalischen Entwicklern bearbeitet werden, muß die Abdeckschicht 5 wenn sie eine Gelatineschicht ist, nach der Photolackentwicklung mit einer geringfügig alkalischen Lösung, z.B. einer Sodalösung, an den nicht mehr durch die Photolackschicht 6 abgedeckten Stellen entfernt werden. Dabei muß natürlich der abdeckende und lichtgehärtete Photolack der Lackschicht 6 eine hinreichende Widerstandsfähigkeit gegen die alkalische Lösung aufweisen. Aus Wachs bestehende Abdeckschichten 5 können mit Benzin oder einer Benzin-Wasser-Emulsion nach der Entwicklung der lichthärtbaren Photolackschicht 6 ausgewaschen werden.

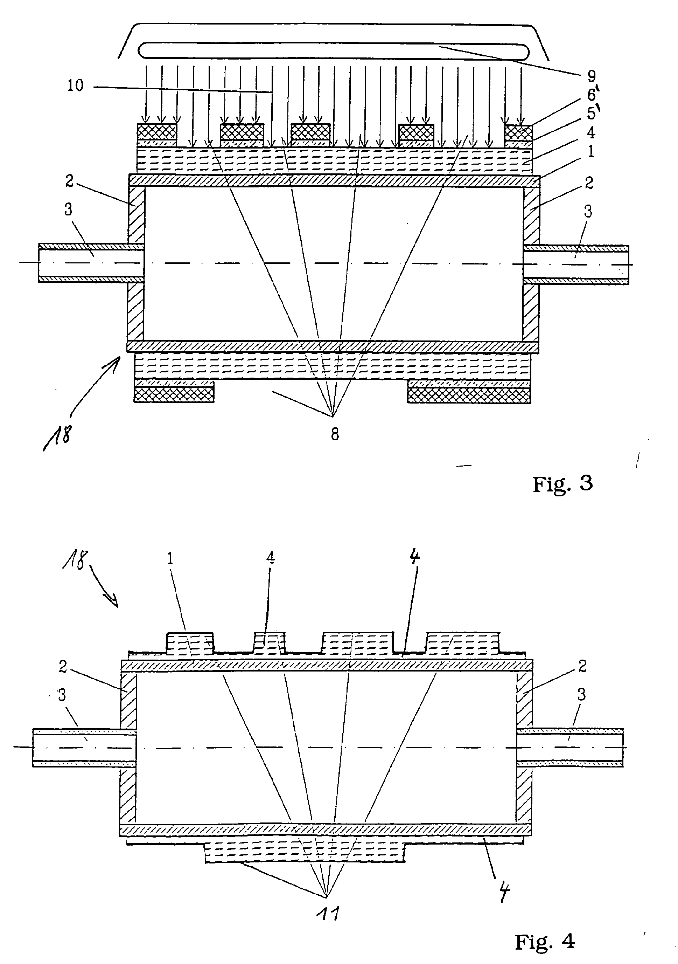

Als Resultat dieses Musterbildungsprozesses ergibt sich die in Fig.2 dargestellte Druckform 18, bei der die erste strahlungsempfindliche Schicht, also im Ausführungsbeispiel die Photoelastomerschicht 4 mit einer Bestrahlungsmaske 5' abgedeckt ist und somit mustergemäß freigelegte Stellen 8 aufweist, durch die die Belichtung der Photoelastomerschicht 4 erfolgen kann. Wie in Fig.3 dargestellt, erfolgt die Belichtung der Photoelastomerschicht 4 großflächig für mehrere Minuten mit einem von einer Lampe 9, insbesondere einer Xenonlampe erzeugten Lichtband 10. Anstelle der Xenonlampe kann auch eine Metall-Halogen-Dampflampe treten. Metall-Halogen-Dampflampen sind dabei energiebilanzmäßig vorteilhaft, da sie Licht nur im Bereich der Empfindlichkeitsmaxima der üblichen Photopolymere emittieren, und kaum Wärmestrahlung aussenden, so daß die Oberfläche der Druckform 18 nicht unzulässig erwärmt wird.

Die belichteten Stellen der Photoelastomerschicht 4 werden bei entsprechend langer Belichtungszeit tief und nachhaltig vernetzt. Hierbei ist es zweckmäßig die Photoelastomerschicht 4 nur solange mit der Lampe 9 zu belichten, bis die Vernetzung für den nachfolgenden Entwicklungsvorgang an den belichteten Stellen 8 gerade ausreicht, das heißt, das die vernetzten Stellen dem chemischen und mechanischen Angriff während der Entwicklung gerade hinreichend widerstehen können. Dies hat den Vorteil, daß die von der Abdeckschicht 5 abgedeckten Bereiche der Photoelastomerschicht 4 selbst dann unvernetzt bleiben, wenn die UV-lichtdichte Abdeckung durch die Abdeckschicht 5 möglicherweise unvollständig ist, wenn also ein geringer Teil des auf die Abdeckschicht 5 auftreffenden UV-Lichts durch die Abdeckschicht 5 hindurch gelangen könnte.

Nach der in Fig.3 dargestellten Belichtung der Photoelastomerschicht 4 wird die Druckform 18 bzw. die Photoelastomerschicht 4 entwickelt, um die in Fig.4 dargestellte fertige Druckform 18 zu erhalten. Hierzu wird die Druckform in ein Entwicklungsbad mit einem wiederum alkalischen Entwickler gebracht. Dieser istjetzt so alkalisch, daß die relativ dünne Photolackschicht 6, die beispielsweise etwa 10 µm dick ist, genauer gesagt die mustergemäß noch vorhandenen und gehärteten Bereiche dieser Photolackschicht 6 trotz ihrer Vernetzung sofort angegriffen und abgetragen werden. Dabei wird auch die aus Gelatine oder Wachs bestehende Bestrahlungsmaske 5' entfernt. Selbst wenn diese beiden Schichten durch den zum Entwickeln des Photopolymers der Photoelastomerschicht 4 gebrauchten Entwickler nicht angegriffen werden, sind die während des Entwicklungsprozesses ausgeübten mechanischen Beanspruchungen der Abdeckschicht 5 und der Photolackschicht 6 so groß, daß die beiden relativ dünnen Schichten rein mechanisch sehr schnell abgetragen werden. Nachdem vollständigen Abtragen der Photolackschicht 6 und der Bestrahlungsmaske 5' hat der Entwickler ungehindert Zutritt zu den unbelichteten oder allenfalls nur schwach belichteten Stellen der Photoelastomerschicht 4 und beginnt das Photopolymer abzutragen. Unterstützt wird die chemische Entwicklung durch ein intensives mechanisches Bürsten der zu entwickelnden Photoelastomerschicht 4 im Entwicklerbad.

Bei der in Fig.4 dargestellten fertigen Druckform 18 nach dem Entwickeln entsprechen die erhabenen Stellen 11 den durch die Lichteinwirkung vernetzten Bereichen der Photopolymerschicht 4.

Zweckmäßigerweise wird das erfindungsgemäße Verfahren für die Herstellung von zylindrischen Druckformen, insbesondere bei der Herstellung von zylindrischen Flexodruckformen mit Belichtungs- und Entwicklungseinrichtungen durchgeführt, wie sie im folgenden beschrieben werden.

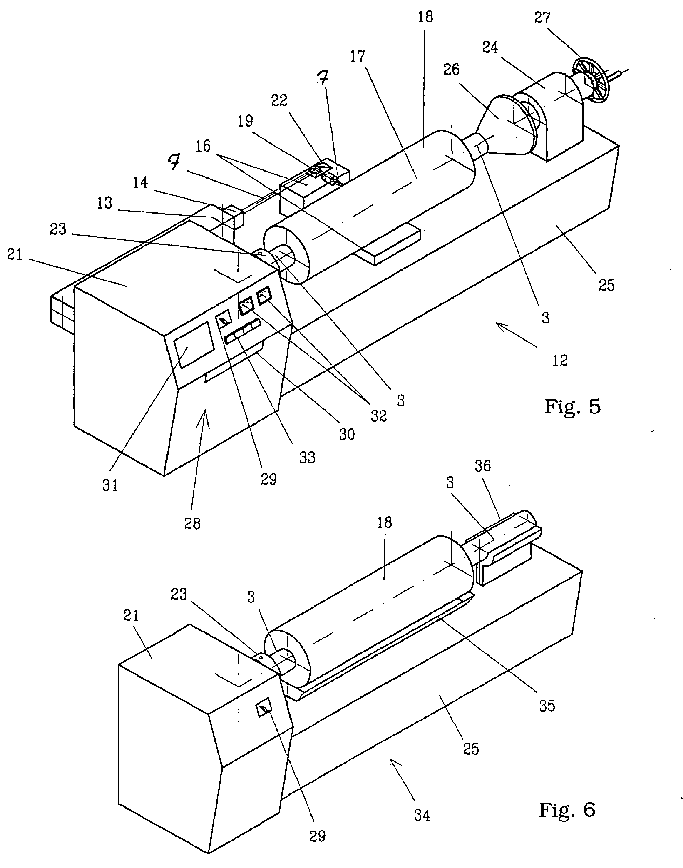

Obwohl die Belichtung der zweiten strahlungsempfindlichen Schicht, also der Photolackschicht 6 mit jeder auf die Empfindlichkeit der Photolackschicht 6 abgestimmten Strahlungs- oder Lichtquelle in jeder bekannten Weise erfolgen kann, wird diese Belichtung vorzugsweise mit einer Belichtungsvorrichtung 12 durchgeführt, wie sie in Figur 5 gezeigt ist. Die Belichtungsvorrichtung 12 weist einen Laser 13, insbesondere einen ArgonIonen-Laser, auf, der den Laserstrahl 7 emittiert. Der Laserstrahl 7 besitzt dabei einen Durchmesser von etwa 1 bis 3 mm und einen sehr geringen Divergenzwinkel. Auf einem Schlitten 16, der in Richtung der Achse 17 der Druckform 18 langsam verfahren werden kann, ist ein Umlenkspiegel 19 montiert, der den Laserstrahl 7 auf die zylindrische Oberfläche der Druckform 18, also auf die zylindrisch liegende Photolackschicht 6 richtet. Vor der Auftreffstelle des Laserstrahls 7 auf die Druckform 18 ist eine Linsenanordnung oder eine Laseroptik 22 vorgesehen, die den Laserstrahl 7 im Bereich der Auftreffstelle auf einen Durchmesser von etwa 30 µm fokussiert. Obwohl die Druckform 18 praktisch rund läuft, kann es bei einzelnen Druckformen gelegentlich noch zu einem Rundlauffehler von etwa 0,1 mm kommen. Die Laseroptik 22 wird zweckmäßigerweise mit einer Brennweite von etwa 50 bis 150 mm ausgeführt. Bei einem Laser 13 mit geringem Strahldivergenzwinkel variiert der Durchmesser der Strahltaille im Bereich des Fokus bei einer Rundlaufabweichung der Druckform 18 von 0,1 mm um maximal 1%, so daß auf eine Nachführung oder Nachregelung der Laseroptik 22 verzichtet werden kann.

Während der mustergemäßen Belichtung der Photolackschicht 6 rotiert die Druckform 18 mit gleichmäßiger Geschwindigkeit, so daß der Belichtungslichtfleck auf der Photolackschicht 6, also auf der Oberfläche der Druckform 18 eine Schraubenlinie beschreibt. Die Rotationsbewegung wird der Druckform 18 dabei von einem in einem Spindelstock 21 untergebrachten Antrieb erteilt, mit welchem der linke Achsstummel 3 über ein Spannfutter 23 verbunden ist. Der rechte Achsstummel 3 der Druckform 18 wird dabei von einem Reitstock 24 gehalten. Unterhalb der Druckform 18 befindet sich das Bett 25 der Belichtungsvorrichtung 12, das den Spindelstock 21 mit dem Reitstock 24 ähnlich wie bei einer Drehbank verbindet. Das Bett 25 der Belichtungsvorrichtung 12 führt dabei den Schlitten 16 während seiner Bewegung parallel zur Achse 17 der Druckform 18.

Ein Stützkegel 26 am Reitstock 24 greift in das hohle Ende des rechten Achsstummels 3 ein und ist mittels eines Handrads 27 am Reitstock auf verschiedene Druckformlängen feinfühlig einstellbar. Eine zusätzliche Grobeinstellung kann durch Verschieben des Reitstocks 24 in Richtung der Achse 17 der Druckform 18 auf dem Bett 25 erfolgen. Am Spindelstock 21 ist ferner ein Bedienfeld 28 zu erkennen. Ein Hauptschalter 29 dient für das elektrische Anschließen an das bzw. für das Trennen vom Netz. Für die bequeme Einstellung verschiedener notwendiger Arbeitsparameter wie Maschinendrehzahl, Auflösung des Musters und dergleichen ist eine Eingabetastatur in einer ausziehbaren Lade 30 vorgesehen. Die Eingabedaten, der Arbeitsfortschritt und gegebenenfalls Störungsmeldungen werden über einen Monitor 31 ausgegeben. Auf dem Monitor 31 kann auch das jeweils abzuarbeitende Muster dargestellt werden. Für die Überwachung sehr wesentliche Betriebsdaten werden zusätzlich auf Instrumenten 32 laufend angezeigt. Die Schalterreihe 33 enthält einen Notstopptaster, Taster für das Zu- und Abschalten des Monitors 31 und Taster für das manuell gesteuerte Verschieben des Schlittens 16 während der Einrichtphase.

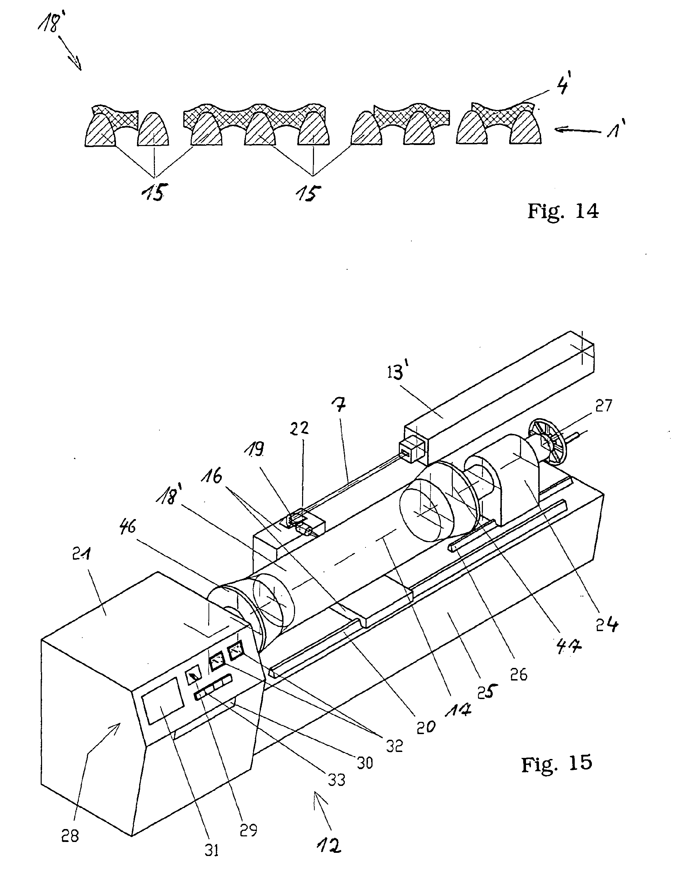

Die hier beschriebene Belichtungsvorrichtung 12 ist hinsichtlich der Halterung und dem Antrieb der Druckform 18 an eine Flexodruckform angepaßt, wie sie beispielsweise in Fig.4 gezeigt ist. Für andere zylindrische Druckformen, ist die Lagerung der zylindrischen Druckform und deren Antrieb in entsprechender Weise geeignet auszuführen, und ist beispielsweise für Siebdruckzylinder in Figur 15 gezeigt und wird weiter unten erläutert.

Anstelle der schraubenförmigen Belichtung der zylindrischen Photolackschicht 6 mit einem einzelnen Lichtfleck kann die Belichtung auch mit mehreren in Längsrichtung der Achse 17 der Druckform 18 nebeneinander angeordneten Lichtflecken gleichzeitig erfolgen. Dabei wird beispielsweise während einer Drehung der Druckform 18 ein zylindrischer Musterstreifen belichtet. Bei der folgenden Drehung wird dann der Schlitten 16 um die Breite des belichteten Musterstreifens verschoben um einen nahtlos daran anschließenden Musterstreifen bei der folgenden Drehung der Druckform 18 zu belichten wonach wiederum eine entsprechende Verschiebung des Schlittens 16 erfolgt.

Nach der Belichtung der Druckform 18 in der Belichtungsvorrichtung 12 erfolgt die Entwicklung der Photolackschicht 6 mit Hilfe eines flüssigen Entwicklers in einer Entwicklungsvorrichtung 34, wie sie beispielsweise in Fig.6 dargestellt ist. In dieser Entwicklungsvorrichtung rotiert die Druckform 18 nur langsam während ihre Oberfläche in eine flache Tasse 35, die den flüssigen Entwickler enthält, mit geringer Tiefe eintaucht. Angetrieben wird die Druckform 18 von einem Antrieb im Spindelstock 21 über ein Spannfutter 23, das den in Fig.6 linken Achsstummel 3 der Druckform 18 trägt. Der rechte Achsstummel 3 kann wegen der sehr geringen Drehzahl einfach in einer offenen Lagerhalbschale 36 abgestützt werden.

Mittels eines Hauptschalters 29 wird die Drehbewegung der Druckform 18 ein- bzw. ausgeschaltet. Für die Entwicklung ist ein Zeitaufwand von wenigen Minuten erforderlich. Nach Abschluß der Entwicklung sind je nach Art des verwendeten Lacktyps, also je nach dem ob ein mit Licht härtbarer oder mit Licht zersetzbarer Photolack die unbelichteten oder die belichteten Stellen der Photolackschicht 6 abgetragen. Bei der Entwicklung der Druckform 18 bzw. der Photolackschicht 6 wird meistens auch gleichzeitig die nicht mehr durch den Photolack der Photolackschicht 6 abgedeckten Stellen der Abdeckschicht 5 abgetragen. Sollte der Entwickler hierfür nicht geeignet oder erschöpft sein, dann kann auf derselben Entwicklungsvorrichtung mit einem anderen Bad auch die Abdeckschicht 5 abgetragen werden. Die letzten Reste des Entwicklers bzw. des letzten Bades werden nach Anschluß der Entwicklung durch Spülen mit Leitungswasser entfernt.

Die auf der in Fig.6 gezeigten Entwicklungsvorrichtung 34 entwickelte Druckform 18 weist den in Fig.2 dargestellten Schichtaufbau mit noch unbehandelter Photoelastomerschicht 4 und mustergemäß strukturierter Abdeckschicht 5 und Photolackschicht 6 auf.

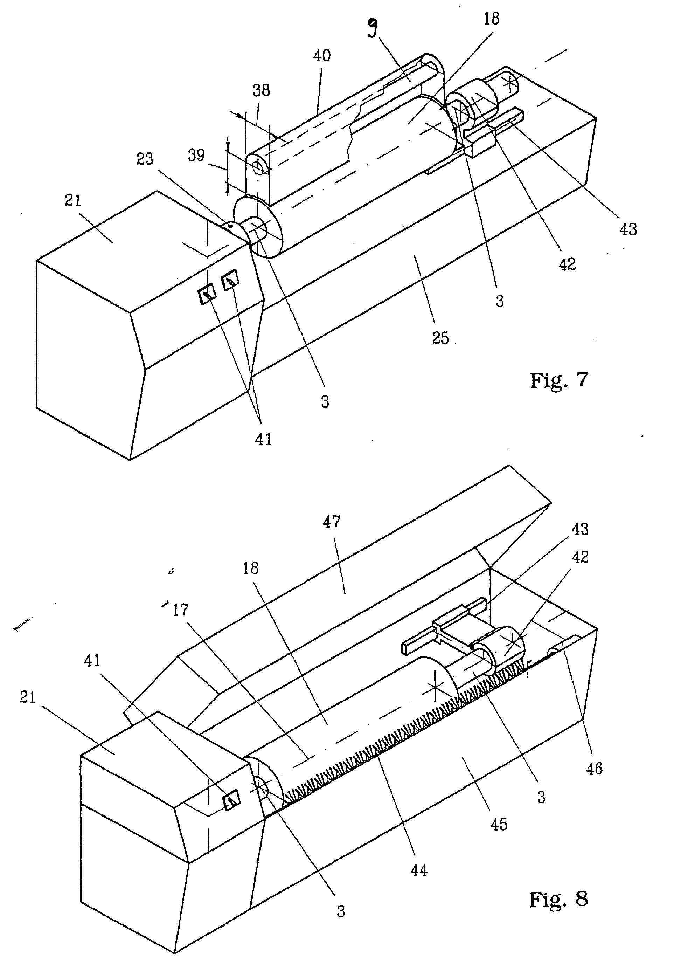

Die so vorbereitete Druckform 18 wird dann beispielsweise in einer Belichtungsvorrichtung, wie sie in Fig.7 gezeigt ist, großflächig belichtet. Hierfür weist die Belichtungsvorrichtung eine Lampe 9 auf, die beispielsweise eine Metall-Halogen-Dampflampe ist. Die Lampe 9 hat dabei zweckmäßigerweise die Form eines Lampenbalkens mit kreisrundem Querschnitt und erstreckt sich über die gesamte Länge der Druckform 18. Wesentlichen Einfluß auf die Qualität der Gravur haben die in Umfangsrichtung der Druckform 18 gesehene Breite 38 eines Lampengehäuses 40 und der Abstand 39 der Lampe 9 von der Druckform 18 in Radialrichtung. Die Breite 38 des Lampengehäuses 40 sollte ein Drittel des Durchmessers der Druckform 18 nicht überschreiten, da sonst durch Unterstrahlungseffekte auch die Randbereiche der durch die Abdeckschicht 5 abgedeckten Stellen der Photoelastomerschicht 4 vernetzt und damit gehärtet werden. Dies ist nicht erwünscht, da dadurch die Linienschärfe des Musters beeinträchtigt wird.

In besonderen Fällen wird die Breite 38 des Lampengehäuses 40 sogar nur auf etwa 10% des Durchmessers der Druckform 18 beschränkt. Ein größerer Abstand 39 und eine kleinere Breite 38 erhöht die Konturentreue, verlängert aber wegen der geringeren beleuchteten Fläche auf der Druckform 18 und der geringeren Beleuchtungsstärke die notwendige Belichtungszeit. Ein kleinerer Abstand 39 und eine größere Breite 38 bewirken das Gegenteil.

Am Spindelstock 21 sind je ein Schalter 41 für den Drehantrieb der Druckform 18 und die Lampe 9 vorgesehen. Zweckmäßigerweise sind die Schalter elektrisch so verriegelt, daß die Lampe 9 nur dann eingeschaltet werden kann, wenn die Druckform 18 bereits dreht. Der rechte Achsstummel 3 der Druckform 18 ist dabei in einem aufklappbaren Stützlager 42 drehbar gelagert, das auf einer Führung 43 in eine der Länge der Druckform 18 angemessene Position gebracht werden kann.

Nach der zweiten Belichtung der Druckform 18, also nach der großflächigen Belichtung der Photoelastomerschicht 4 wird die Druckform 18 in einer weiteren Entwicklungsvorrichtung abschließend entwickelt.

Wie in Fig.8 gezeigt, wird die Druckform 18 in einer Wanne 45 drehbankähnlich gelagert, so daß sie von einem nicht dargestellten Drehantrieb in einem Spindelstock 21 in Drehung versetzt werden kann. Durch die Betätigung eines Schalters 41 wird der Drehantrieb im Spindelstock 21 eingeschaltet und die Druckform 18 in drehende Bewegung versetzt. Außerdem wird eine Bürstwalze 44 mit relativ hoher Drehzahl angetrieben. Die Druckform schöpft aus einem nicht sichtbaren Entwicklersumpf in der Wanne 45 laufend Entwicklerflüssigkeit während zusätzlich auf die Bürstwalze 44 Entwicklerflüssigkeit aus einer durch die vordere Wand der Wanne 45 verdeckten und daher nicht sichtbaren Düsenleiste aufgespritzt wird.

Der intensive Kontakt der Photoelastomerschicht 4 der Druckform 18 mit der Entwicklerflüssigkeit und die intensive mechanische Abrasion durch die rotierende Bürstwalze 44 sorgen für ein rasches Abtragen bzw. Auswaschen aller nichtvernetzten Bereiche der Photopolymerschicht 4, von der nach Abschluß der Entwicklung nur die vernetzten Bereiche und eine dünne noch nicht vernetzte Basisschicht verbleiben, welche für die Befestigung des Photoelastomers am Trägerrohr 1 notwendig ist. Diese dünne Basisschicht 4 wird nicht aufgelöst und ausgewaschen, um auch kleinere vernetzte Bereiche des Photoelastomers zuverlässig am Trägerrohr 1 befestigen zu können.

Der Entwicklungsvorgang wird daher zu einem vorbestimmten Zeitpunkt abgebrochen.

Auch in der Entwicklungsvorrichtung wird der vom Spindelstock 21 abgewandte rechte Achsstummel 3 der Druckform 18 von einem einfachen Stützlager 42 gehalten, das auf einer Führung 43 in Richtung der Achse 17 der Druckform 18 verschiebbar angeordnet ist, um verschieden lange Druckform 18 in die Entwicklungsvorrichtung einlegen zu können.

Zum leichteren Einlegen und Herausnehmen der Druckform 18 ist das Stützlager 42 geteilt ausgeführt. Die obere Hälfte kann nach Entriegelung nach oben geklappt werden. Die Bürstwalze 44 ist an ihren beiden Enden in Gleitlagerbüchsen 46 drehbar gelagert. Da während des Entwicklungsvorgangs und dem hierzu notwendigen intensiven Bürsten der Oberfläche der Druckform 18 die Entwicklerflüssigkeit stark verspritzt wird, weist die Entwicklungsvorrichtung zweckmäßigerweise einen Klappdeckel 47 auf, der die Wanne 45 dicht verschließt.

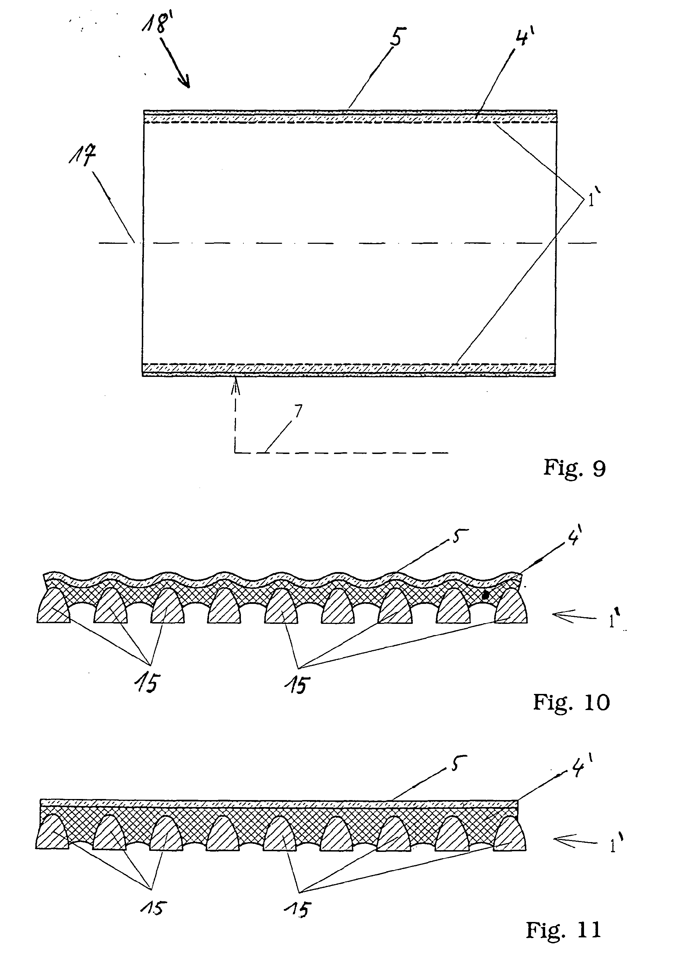

Ein weiteres Ausführungsbeispiel der Erfindung wird anhand der Herstellung einer Siebdruckschablone unter Bezugnahme auf die Figuren 9 bis 17 näher erläutert.

Die Figur 9 zeigt einen Rohling für eine Siebdruckschablone 18', die im folgenden der Einfachheit halber unabhängig von der Herstellungsstufe als solche bezeichnet wird. Die Siebdruckschablone 18' weist als Träger einen dünnen Siebzylinder 1' auf, auf den als erste strahlungsempfindliche Schicht eine Photolackschicht 4' gelegt ist, die mit einer Abdeckschicht 5 überzogen ist. Die Photolackschicht 4' kann aus Gelatine oder Polyvinylalkohol bestehen, die mit Kaliumbichromat versetzt wird. Bei Einwirkung kurzwelliger Strahlung im UV-Bereich vernetzt eine so behandelte Gelatine oder ein so behandelter Polyvinylalkohol auch im trockenen Zustand und der Lack wird damit wasserunlöslich und wesentlich beständiger gegenüber chemischen Angriffen, wie diese etwa bei Einwirkung eines Entwicklers oder von Druckchemikalien auftreten.

Die nicht vernetzte bzw. nicht gegerbte Gelatine und ebenso der nicht gegerbte Polyvinylalkohol läßt sich hingegen durch warmes Wasser oder eine alkalische wässrige Lösung sehr leicht herauswaschen. Dieser Vorgang wird als Entwicklung bezeichnet.

Für die Photolackschicht 4' kann auch Epoxy- oder Methylmethacrylat verwendet werden. Diese Harze werden meist mit einem alkoholischen oder ketonischen Lösemittel verdünnt oder in Form einer wässrigen Emulsion solcher Lösungen verwendet und enthalten häufig zur Steigerung der Lichtempfindlichkeit oder der Verlagerung der Empfindlichkeit in einen längerwelligen Lichtbereich einen optischen Sensibilisator. Auch so aufgebaute Photolackschichten werden durch die Einwirkung von Licht photosynthetisch vernetzt bzw. gehärtet.

Neben derartigen Negativlacken können für die Photolackschicht 4' auch sogenannte Positivlacke eingesetzt werden, bei denen durch Strahlungs- oder Lichteinwirkung der ansonsten unlösliche Lack geschädigt und damit für den Angriff eines nachfolgend eingesetzten Entwicklers empfindlich gemacht wird.

Für die Abdeckschicht 5 werden die gleichen Lösungsmittel, schichtbildenden Substanzen und UV-absorbierenden oder UV-reflektierenden Stoffe eingesetzt wie bei der anhand des ersten Ausführungsbeispiel beschriebenenAbdeckschicht 5. Neben der Verwendung von schwarzen Pigmenten, wie z. B. Ruß (Black Carbon) können bei Abdeckschichten auch andere Farbstoffe wie beispielsweise Sudan Blue der Firma BASF oder Kombinationen von farbigen Farbstoffen, wie eine Mischung aus Sudan Blue Farbstoff mit Novaperm Yellow Pigment der Firma Hoechst eingesetzt werden.

Das Auftragen der Photolackschicht 4' und der Abdeckschicht 5 erfolgt vorzugsweise mit dem oben beschriebenen Tauchbeschichtungsverfahren. Dies hat insbesondere für das Aufbringen der Abdeckschicht 5 den Vorteil, daß diese Schicht selbst dann mit über die gesamte Siebdruckschablone gleicher Dicke aufgetragen werden kann, wenn die Photolackschicht 4' infolge eines trocknungsbedingten Schrumpfens eine wellige Oberfläche aufweist, wie beispielsweise in Figur 10 dargestellt.

Es ist noch darauf hinzuweisen, daß die Photolackschicht 4' vor dem Aufbringen der Abdeckschicht 5 und ebenso die Abdeckschicht 5 nach ihrem Aufbringen getrocknet werden, wenn diese Schichten Wasser oder andere Lösungsmittel enthalten. Das Trocknen wird dabei meist in einem Warmluftofen ausgeführt, in dem die Umluft kontinuierlich gefiltert wird.

In Figur 10 ist zu erkennen, daß der Siebzylinder 1' aus einzelnen Stegen 15 besteht, die galvanoplastisch aufgebaut sind. Anstelle eines galvanoplastisch aufgebauten Siebzylinders 1' kann auch ein Siebzylinder aus einem Metallgewebe verwendet werden. Darüber hinaus ist es insbesondere bei ebenen Siebdruckschablonen möglich. Textilgewebe einzusetzen, insbesondere feines Seidengazegewebe, um die mit der fertigen Siebdruckschablone erzielbare Druckqualität weiter zu verbessern. Bei der Verwendung von Textilgeweben ist es zweckmäßig, eine die Siebstruktur nicht beeinträchtigende Metallbeschichtung vorzusehen, um beim Abtragen der Abdeckschicht 5 und beim Belichten der Photolackschicht 4' eine Beschädigung des Siebgewebes durch die verwendete Strahlung zu verhindern.

Die in Figur 10 dargestellte Photolackschicht 4' zeigt eine unebene Oberfläche, da sie aus einem stark Lösemittel haltigem Lack aufgebaut ist, wodurch die Photolackschicht 4' während derTrocknung durch dasAbdampfen des Lösemittels stark geschrumpft ist. Die Photolackschicht 4' in Figur 11 besteht hingegen aus einem polymerisierenden Lacksystem, so daß diese Schicht geringfügig schrumpft und somit eine ebene bzw. glatte Oberfläche beibehält.

Die auf die Photolackschicht 4' nach Figur 10 aufgetragene Abdeckschicht 5 bleibt dank des verwendeten Tauchbeschichtungsverfahrens überall gleich dick.

Um eine mustergemäß strukturierte Strahlungsmaske 5' zu erhalten, wird die Abdeckschicht 5 mustergemäß abgetragen. Dies kann beispielsweise mechanisch oder chemisch erfolgen.

Soll die Abdeckschicht 5 chemisch abgetragen werden, so ist beispielsweise eine Strukturierungsmaske aus Wachs oder Harz mustergemäß aufzuspritzen, die einem nachfolgenden Ätzangriff auf die Abdeckschicht 5 standhält, so daß die Abdeckschicht 5 an den durch die Strukturierungsmaske abgedeckten Stellen auf der Siebdruckschablone verbleibt während sie an den nichtabgedeckten Stellen abgetragen wird.

Bei einem nicht der Erfindung entsprechenden Beispiel wird die Abdeckschicht mit Hilfe von Strahlung abgetragen. Vorzugsweise wird hier Laserstrahlung verwendet, deren Wellenlänge vom nahen Infrarotbereich (800 nm bis 1 µm bei Verwendung von Laserdioden; 1,06 µm bei Verwendung eines Nd-YAG-Lasers) bis zum thermischen Strahlungsbereich (10,6 µm bei einem CO₂-Laser) reicht. Das Abtragen der Abdeckschicht 5 erfolgt dabei durch Abdampfen. Es ist jedoch auch möglich, die Abdeckschicht 5 durch Photolyse abzutragen, wobei dann auch kürzere Wellenlängen, die im sichtbaren Bereich liegen, zur Anwendung gelangen. Eine Strahlung im UV-Bereich und im kurzwelligen Spektralbereich des sichtbaren Lichtes mit Wellenlängen bis etwa 500 nm wird allerdings nur dann verwendet, wenn die unter der Abdeckschicht 5 liegende Photolackschicht 4' unter der Einwirkung der später erfolgenden großflächigen Nachbelichtung vernetzt bzw. härtet, also aus einem polymerisierenden Harzsystem aufgebaut ist.

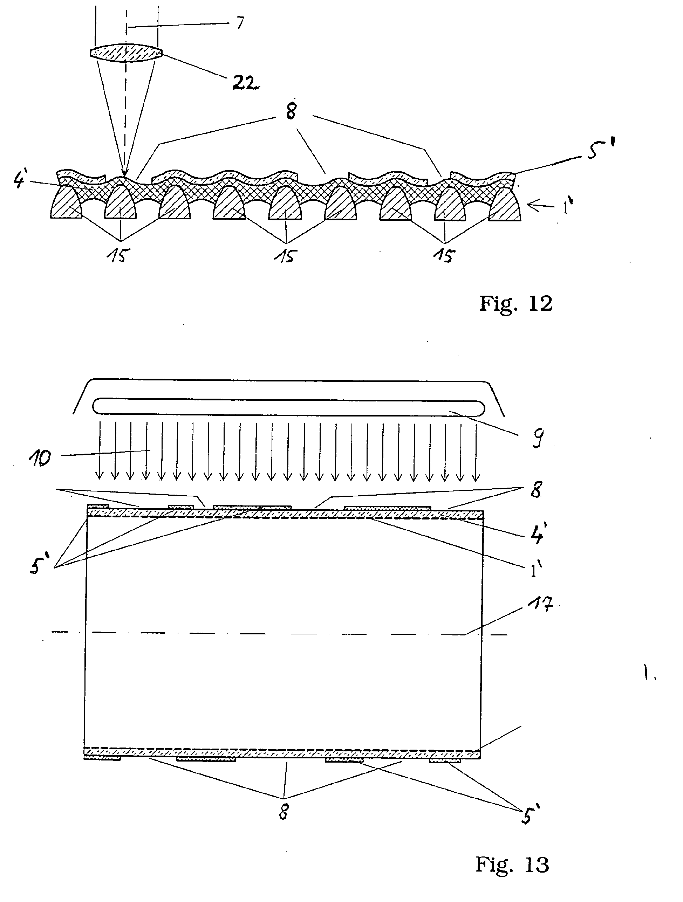

Figur 12 zeigt eine aus der Abdeckschicht 5 hergestellte Bestrahlungsmaske 5', die mustermäßig so durch die thermische Wirkung eines Laserstrahls 7 abgelöst wurde, daß die Photolackschicht 4' musterbedingt freigelegte Stellen 8 aufweist, an denen die Photolackschicht 4' bei der nachfolgenden, in Figur 13 gezeigten großflächigen Belichtung entweder photolytisch geschädigt oder aber gehärtet werden soll.

Der zum unmittelbaren musterbedingten Abtragen der Abdeckschicht 5 eingesetzte Laserstrahl 7 wird durch eine Laseroptik 22 so fokussiert, daß er an der Auftreffstelle einen Durchmesser von 20 bis 40 µm aufweist. Der verwendete Laserstrahl 7 hat dabei vor der Laseroptik 22 einen kleinen Strahldivergenzwinkel, so daß bei den verwendeten Brennweiten zwischen 50 nm und 150 nm eine Strahltaille im Fokus, also an der Auftreffstelle entsteht, die sich in einem Bereich von 0,1 mm senkrecht zur Oberfläche des Siebzylinders 1' gemessen nur um wenige Prozente ändert, so daß ein Rundschlag in der Größenordnung von 0,1 mm praktisch keinen Einfluß auf die Konturtreue der Gravur hat.

Nach der vorzugsweise mit einem Laser durchgeführten mustergemäßen Abtragung der Abdeckschicht 5 zur Ausbildung einer Bestrahlungsmaske 5' wird die Photolackschicht 4' großflächig mit einem von einer Lampe 9 emittierten Lichtband belichtet. Als Lampe 9 wird dabei vorzugsweise eine Metallhalogenlampe verwendet. Bei diesem Lampentyp liegen die Maximalwerte der Emissionsenergie bei Wellenlängen zwischen 290 und 540 nm, so daß die Photolackschicht also mit energiereicher UV-Strahlung bestrahlt wird, die starke photochemische Wirkungen nach sich zieht. Je nach verwendetem Lacktyp wird die Photolackschicht 2 an dem bestrahlten Stellen entweder geschädigt oder gehärtet. Im Fall einer photolytischen Schädigung der Photolackschicht kann diese chemisch durch einen alkalischen Entwickler leicht angegriffen, zersetzt und dadurch abgelöst werden. Als Beispiel sei hier ein Diazoharz genannt, bei welchen sich unter der Einwirkung von UV-Strahlung feinste Stickstoffbläschen im Photolack bilden, so daß ein Entwickler leicht in das Harz eindringen und dieses zersetzen kann. Im Falle von Lacken, die unter der Einwirkung von UV-Strahlung vernetzt sind, wird die Photolackschicht 4' an den bestrahlten Stellen chemisch sehr widerstandsfähig und die nicht bestrahlten Stellen dieser Schicht können während der nachfolgenden Entwicklung durch Warmwasser oder durch einen Entwickler vom Siebzylinder 1' abgelöst werden. Figur 14 zeigt eine unter Verwendung eines Positivlacks hergestellte Siebdruckschablone 18' im vergrößerten Schnitt.

Die in Figur 15 gezeigte Belichtungsvorrichtung 12, auf der das laseroptische Ablösen der Abdeckschicht 5 zur Ausbildung einer Bestrahlungsmaske 5' entsprechend den Erfordernissen des in die Photolackschicht 4 einzubringenden Musters durchgeführt wird, ist ähnlich wie eine Drehbank aufgebaut. Ein Neodym-Yag Laser 13' emittiert einen Laserstrahl 7, der eine Wellenlänge von 1,06 µm und einen Durchmesser von wenigen Millimetern sowie einen sehr geringen Divergenzwinkel aufweist. Gegebenenfalls werden diese Eigenschaften des Laserstrahls 7 durch eine Aufweitungsoptik, die knapp hinter dem Austrittsfenster des Laser vorgesehen sein kann, sichergestellt.

Anstelle eines Nd-YAG-Lasers, der durch Laserdioden gepumpt wird, kann auch ein CO₂-Laser eingesetzt werden, der durch Ein- und Ausschalten einer elektrischen Entladungsstrecke gepulst wird. Im letzteren Fall lassen sich Schaltfrequenzen von 10 bis 20 kHz erreichen, während durch Ein- und Ausschalten der Laserdioden im ersten Fall Schaltfrequenzen bis etwa 50 kHz erreichbar sind. Falls noch höhere Schaltfrequenzen benötigt werden, kann der Laser auch im Dauerbetrieb arbeiten und der Strahl mit einem akusto- oder elektrooptischen Schalter unterbrochen werden.

Der Vorteil einer Abtragung der Abdeckschicht 5 mit einer Wellenlänge oberhalb von 800 nm besteht darin, daß weder eine Vorvernetzung noch eine photolytische Zersetzung der unter der Abdeckschicht 5 liegenden Photolackschicht 4' erfolgen kann, weil für beide Effekte Licht mit höherer Quantenenergie und somit kürzerer Wellenlänge erforderlich ist. Natürlich ist eine genaue Dosierung der optischen Strahlenergie des Laserstrahls 7 erforderlich, da sich die Photolackschicht 4' sonst thermisch zersetzen kann.

Auf einem Schlitten 16, der in Richtung der Achse 17 der Siebdruckschablone 18' langsam verfahren wird, ist ein Umlenkspiegel 19 montiert, der den Laserstrahl 7 auf die Oberfläche der Siebdruckschablone 18' richtet. Zur Fokussierung des Laserstrahls 7 ist dabei eine Laseroptik 22 hinter dem Umlenkspiegel 19 vorgesehen.

Während der Belichtung rotiert die Siebdruckschablone 18' mit gleichmäßiger Geschwindigkeit, so daß der Lichtfleck des Laserstrahls 7 eine Schraubenlinie auf der Oberfläche der Siebdruckschablone 18' beschreibt. Diese Rotationsbewegung wird der Siebdruckschablone 18' von einem im Spindelstock 21 untergebrachten Antrieb erteilt, mit welchem die linke Stirnseite der Siebdruckschablone 18' über einen Mitnahmekonus 46 verbunden ist. Die rechte Stirnseite der Siebdruckschablone 18' wird von einem Zentrierkonus 47 am Reitstock 24 gehalten.

Unterhalb der Siebdruckschablone 18' befindet sich das Bett 25 der Belichtungsvorrichtung 12, das den Spindelstock 21 mit dem Reitstock 24 verbindet und Führungen 20 für den Schlitten 16 trägt, die diesen während seiner Arbeitsbewegung genau parallel zur Achse 17 der Siebdruckschablone 18' führen.

Um verschieden lange Siebdruckschablonen 18' bearbeiten zu können, ist der Reitstock 24 in Axialrichtung verstellbar, während der Zentrierkonus 47, der in das rechte stirnseitige Ende einer Siebdruckschablone 18' eingreiftzur Feineinstellung mittels eines Handrades 27 am Reitstock 24 fein verstellbar ist.

Am Spindelstock 24 sind ferner die gleichen Bedienungs- und Anzeigeeinrichtungen angeordnet, wie sie bei der anhand von Figur 5 beschriebenen Belichtungsvorrichtung 12 ebenfalls vorgesehen sind.

Wenn das Abtragen der Abdeckschicht 5 erfindungsgemäß chemisch unter Verwendung einer Strukturierungsmaske durchgeführt werden soll, die auf die Abdeckschicht 5 aufgespritzt wird, so kann eine entsprechende Bearbeitungsvorrichtung verwendet werden, die praktisch genauso aufgebaut ist, wie die anhand von Figur 5 oder 15 beschriebene Belichtungsvorrichtung. Bei einer derartigen Vorrichtung zum Aufspitzen einer Strukturierungsmaske ist dann der Laser weggelassen und anstelle des Umlenkspiegels und der Laseroptik werden auf dem Schlitten 16 Spritzdüsen zum Aufspritzen einer Flüssigkeit angeordnet.

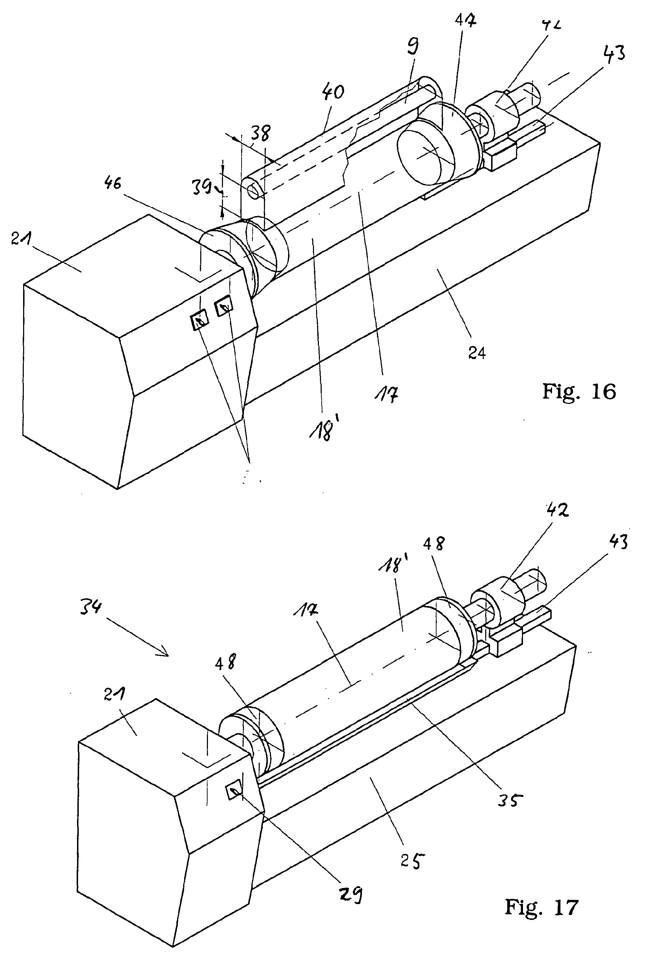

Nach dem mustergemäßen Abtragen der Abdeckschicht 5 zur Ausbildung der Bestrahlungsmaske 5' erfolgt die großflächige Belichtung durch eine Lampe 9 auf einer Belichtungsvorrichtung durchgeführt, die schematisch in Figur 16 dargestellt ist. Die Lampe 9 hat dabei die Form eines Lampenbalkens mit kreisrundem Querschnitt und erstreckt sich über die gesamte Länge der Siebdruckschablone 18'. Obwohl als Lampe 9 unter anderem auch eine Xenondampflampe eingesetzt werden kann, ist eine Metallhalogendampflame hinsichtlich ihrer Energiebilanz vorteilhaft, wenn der verwendete Photolack im UV-Bereich empfindlich ist, da ihre Energiebilanz besser ist, wie oben bereits erläutert wurde.

Die Breite 38 des Lampengehäuses 40 und der Abstand 39 der Lampe 9 von der Oberfläche der Siebdruckschablone 18' haben den bereits bei der Erläuterung der in Figur 7 gezeigten Belichtungseinrichtung beschriebenen Einfluß auf Belichtungszeit und Konturtreue und werden entsprechend gewählt. Abgesehen von dem Mitnahmekonus 46 und dem Zentrierkonus 47 zur Lagerung der Siebdruckschablone 18' ist die Lichtungsvorrichtung nach Figur 16 ebenso aufgebaut, wie die anhand von Figur 7 beschriebene Belichtungsvorrichtung, so daß hier auf eine erneute Beschreibung verzichtet wird.

Nach der großflächigen Belichtung erfolgt die Entwicklung der Photolackschicht 4' auf einer Entwicklungsvorrichtung 34, die in Figur 17 dargestellt ist, und bis auf die Lager für die Siebdruckschablone 18' der in Figur 6 dargestellten Entwicklungsvorrichtung 34 entspricht.

Insbesondere Photolackschichten auf Diazoharzbasis werden meist mit Hilfe einer wässrigen alkalischen Lösung (etwa 2 % Soda und gegebenenfalls geringe Mengen von Natron oder Kalilauge) entwickelt. Für diesen Arbeitsgang rotiert die Siebdruckschablone 18' auf der Entwicklungsvorrichtung 34 sehr langsam, während ihre Oberfläche in eine Tasse 35 eintaucht, die den flüssigen Entwickler enthält. Angetrieben wird die Siebdruckschablone 18' dabei über ein dem Spindelstock 21 zugeordnetes Innenspannfutter 48 während das andere Ende der Siebdruckschablone 18' von einem im Stützlager 42 gehaltenen Innenspannfutter 48 abgestützt wird.

Für diese Entwicklung ist im allgemeinen ein Zeitaufwand von wenigen Minuten erforderlich. Nach Abschluß der Entwicklung sind je nach Art des verwendeten Lacktyps (Positiv- oder Negativlack) die belichteten oder unbelichteten Stellen der Photolackschicht 6 abgetragen. Nach der Entwicklung wird mit Leitungswasser gespült, um alle Reste des Entwicklers zu entfernen.

Wurde für die Photolackschicht 4' ein vernetzender Lack z. B. aus Epoxydharz-. Gelatine- oder Polyvinylalkoholbasis verwendet, so erfolgt die Entwicklung der Photolackschicht 4' einfach durch Spülen mit warmen oder heißen Wasser, in dem die Siebdruckschablone 18' über einem Auffangbecken für das mit Harzresten versetzte Abwasser mit einer Handbrause abgespült wird.

Obwohl anhand der Zeichnung nur die Herstellung zylindrischer Druckformen gezeigt und erläutert wurde, kann das erfindungsgemäße Verfahren auch bei ebenen Druckplatten angewendet werden.

Bei plattenförmigen Druckformen kann dabei die Strukturierung der Abdeckschicht 5, also die Belichtung oder Bestrahlung der zweiten strahlungsempfindlichen Schicht mit einem Belichtungskopf durchgeführt werden, der in zwei vorzugsweise senkrecht aufeinander stehenden Richtungen über der Druckplatte verschiebbar ist.

## Patentansprüche

1. Verfahren zum Herstellen einer Druckform, beim dem
- auf eine auf einem Träger (1, 1') angeordnete erste strahlungsempfindliche Schicht (4, 4') eine strahlungs- bzw. lichtdichte Abdeckschicht (5) aufgetragen wird,
- auf die Abdeckschicht (5) eine Strukturierungsmaske (6') aufgebracht wird, die entsprechend einem gewünschten Muster strukturiert ist.
- die aufgetragene Abdeckschicht (5) unter Benutzung der Strukturierungsmaske (6') entsprechend dem Muster strukturiert wird, um eine Bestrahlungsmaske (5') zu bilden, und
- die erste strahlungsempfindliche Schicht (4) bestrahlt und entwickelt wird.

2. Verfahren nach Anspruch 1, **dadurch gekennzeichnet, daß** die mustergemäß strukturierte Abdeckschicht (5), also die Bestrahlungsmaske (5') beim Entwickeln der ersten strahlungsempfindlichen Schicht (4) entfernt wird.

3. Verfahren nach Anspruch 1 oder 2, **dadurch gekennzeichnet, daß** die Bestrahlungsmaske (5') mechanisch und/oder chemisch entfernt wird.

4. Verfahren nach einem der Ansprüche 1 bis 3, **dadurch gekennzeichnet, daß** die Strukturierungsmaske (6') mustergemäß auf die Abdeckschicht (5) aufgespritzt, insbesondere punktweise aufgespritzt wird, und daß die nichtabgedeckten Teile der Abdeckschicht (5) entfernt werden.

5. Verfahren nach Anspruch 4, **dadurch gekennzeichnet, daß** zum Auftragen der Strukturierungsmaske (6') eine Wachslösung mustergemäß aufgespritzt wird, und daß die nichtabgedeckten Teile der Abdeckschicht chemisch entfernt, vorzugsweise weggeätzt werden.

6. Verfahren nach Anspruch 1, 2 oder 3, **dadurch gekennzeichnet, daß** zum Aufbringen der Strukturierungsmaske (6') eine zweite strahlungsempfindliche Schicht (6) auf die Abdeckschicht (5) aufgetragen, mustergemäß bestrahlt und entwickelt wird, und daß die nichtabgedeckten Teile der Abdeckschicht (5) entfernt werden.

7. Verfahren nach Anspruch 6, **dadurch gekennzeichnet, daß** die zu entfernenden Teile der Abdeckschicht (5) beim Entwickeln der mustergemäß bestrahlten zweiten strahlungsempfindlichen Schicht (6) entfernt werden.

8. Verfahren nach Anspruch 6 oder 7, **dadurch gekennzeichnet, daß** der Strahlungsempfindlichkeitsbereich der zweiten strahlungsempfindlichen Schicht (6) von dem der ersten strahlungsempfindlichen Schicht (4) verschieden ist.

9. Verfahren nach einem der Ansprüche 6 bis 8, **dadurch gekennzeichnet, daß** die zweite strahlungsempfindliche Schicht (6) von einem Photolack gebildet wird, der für sichtbares Licht strahlungsempfindlich ist.

10. Verfahren nach Anspruch 9, **dadurch gekennzeichnet, daß** der Photolack ein Positiv-Lack ist, der durch Licht zersetzbar ist.

11. Verfahren nach einem der Ansprüche 6 bis 10, **dadurch gekennzeichnet, daß** die zweite strahlungsempfindliche Schicht (6) 1 µm bis 20 µm, vorzugsweise 7 µm bis 14 µm, insbesondere 10 µm dick ist.

12. Verfahren nach einem der Ansprüche 6 bis 11, **dadurch gekennzeichnet, daß** die Abdeckschicht (5) auch Strahlung im Strahlungsempfindlichkeitsbereich der zweiten strahlungsempfindlichen Schicht (4, 6) absorbiert.

13. Verfahren nach einem der Ansprüche 6 bis 12, **dadurch gekennzeichnet, daß** zur Bestrahlung der zweiten strahlungsempfindlichen Schicht (6) eine Laserlichtquelle verwendet wird, die vorzugsweise im sichbaren Bereich, insbesondere im Blaubereich Laserlicht emittiert.

14. Verfahren nach einem der Ansprüche 6 bis 13, **dadurch gekennzeichnet, daß** die mustergemäße Bestrahlung der zweiten strahlungsempfindlichen Schicht (6) punkweise erfolgt.

15. Verfahren nach Anspruch 14, **dadurch gekennzeichnet, daß** bei der punkweisen Bestrahlung mehrere nebeneinander liegende Musterpunkte mittels einer entsprechenden Anzahl von Bestrahlungspunkten gleichzeitig mustergemäß bestrahlt werden.

16. Verfahren nach einem der vorstehenden Ansprüche, **dadurch gekennzeichnet, daß** die Abdeckschicht (5) feine lichtabsorbierende und/oder lichtreflektierende Partikel, insbesondere Ruß (Black Carbon) oder feine Metallpartikel, Pigmente und/oder strahlungsabsorbierende Chemikalien enthält.

17. Verfahren nach Anspruch 16, **dadurch gekennzeichnet, daß** die strahlungsabsorbierenden Chemikalien oder Pigmente einer Wachslösung zugesetzt sind, die zur Ausbildung der Abdeckschicht (5) auf die erste strahlungsempfindliche Schicht (4) aufgetragen wird.

18. Verfahren nach Anspruch 16, **dadurch gekennzeichnet, daß** die feinen lichtabsorbierenden oder lichtreflektierenden Partikel in Gelatine oder Polyvinylalkohol suspendiert sind.

19. Verfahren nach Anspruch 18, **dadurch gekennzeichnet, daß** die Suspension von feinen Metallpartikeln in Gelatine durch Reduktion von in Gelatine gelösten Metallsalzen, insbesondere Silberhalogeniden, hergestellt wird.

20. Verfahren nach einem der vorstehenden Ansprüche, **dadurch gekennzeichnet, daß** die Abdeckschicht (5) mit einem Tauchbeschichtungsverfahren aufgetragen wird.

21. Verfahren nach einem der vorstehenden Ansprüche, **dadurch gekennzeichnet, daß** die Abdeckschicht (5) 1 µm bis 20 µm, vorzugsweise 7 µm bis 14 µm, insbesondere 10 µm dick ist.

22. Verfahren nach einem der vorstehenden Ansprüche, **dadurch gekennzeichnet, daß** die erste strahlungsempfindliche Schicht eine Photopolymerschicht, insbesondere eine Photoelastomerschicht (4), z. B. mit einer Dicke von 1 mm bis 10 mm, vorzugsweise von 2 mm bis 5 mm ist.

23. Verfahren nach einem der Ansprüche 1 bis 21, **dadurch gekennzeichnet, daß** die erste strahlungsempfindliche Schicht eine Photolackschicht (4') ist, die vorzugsweise mit einem Tauchbeschichtungsverfahren auf den Träger (1, 1') aufgebracht wird.

24. Verfahren nach Anspruch 23, **dadurch gekennzeichnet, daß** die Photolackschicht (4') aus Gelatine oder Polyvinylalkohol gebildet ist, wobei der Gelatine bzw. dem Polyvinylalkohol ein photosensibles Gerbmittel, beispielsweise Kaliumbichromat, beigefügt ist.

25. Verfahren nach Anspruch 23, **dadurch gekennzeichnet, daß** Photolackschicht (4') aus Kunstharz, vorzugsweise Epoxidharz, Polyesterharz oder Methylmethacrylatharz gebildet ist.

26. Verfahren nach einem der Ansprüche 23, 24 oder 25, **dadurch gekennzeichnet, daß** der Photolackschicht (4') Stoffe zum Vergrößern ihrer Elastizität beigefügt sind, um eine Rissbildung zu verhindern.

27. Verfahren nach einem der vorstehenden Ansprüche, **dadurch gekennzeichnet, daß** der Träger (1) eine vollflächige, geschlossene Oberfläche aufweist, auf der die erste strahlungsempfindliche Schicht (4, 4') aufgebracht ist.

28. Verfahren nach einem der Ansprüche 1 bis 26, **dadurch gekennzeichnet, daß** der Träger (1') für die erste strahlungsempfindliche Schicht (4') ein Sieb ist.

29. Verfahren nach einem der vorstehenden Ansprüche, **dadurch gekennzeichnet, daß** der Träger (1, 1') metallisch ist.

30. Verfahren nach Anspruch 28, **dadurch gekennzeichnet, daß** der Träger (1, 1') aus einem Textilgewebe, insbesondere aus einem Seidengazegewebe, gebildet ist, das vorzugsweise durch eine chemische und/oder galvanische Metallabscheidung verstärkt ist.

31. Verfahren nach einem der vorstehenden Ansprüche, **dadurch gekennzeichnet, daß** der Träger (1, 1') flach ist.

32. Verfahren nach einem der Ansprüche 1 bis 30, **dadurch gekennzeichnet, daß** der Träger (1, 1') zylindrisch ist.

## Claims

1. Process for producing a printing forme, in which
- a radiation-proof or light-proof covering layer (5) is applied to a first radiation-sensitive layer (4, 4') arranged on a carrier (1, 1'),
- a structuring mask (6') is applied to the covering layer(s), which is structured in accordance with a desired pattern,
- the applied covering layer (5) is structured in accordance with the pattern using the structuring mask (6'), in order to form an irradiation mask (5'), and
- the first radiation-sensitive layer (4) is irradiated and developed.

2. Process according to Claim 1, **characterized in that** the covering layer (5) structured in accordance with the pattern, that is to say the irradiation mask (5'), is removed during the development of the first radiation-sensitive layer (4).

3. Process according to Claim 1 or 2, **characterized in that** the irradiation mask (5') is removed mechanically and/or chemically.

4. Process according to one of Claims 1 to 3, **characterized in that** the structuring mask (6') is sprayed onto the covering layer (5) in accordance with the pattern, in particular sprayed on point by point, and **in that** the uncovered parts of the covering layer (5) are removed.

5. Process according to Claim 4, **characterized in that**, in order to apply the structuring mask (6'), a wax solution is sprayed on in accordance with the pattern, and **in that** the uncovered parts of the covering layer are removed chemically, preferably etched away.

6. Process according to Claim 1, 2 or 3, **characterized in that**, in order to apply the structuring mask (6'), a second radiation-sensitive layer (6) is applied to the covering layer (5), irradiated in accordance with the pattern and developed, and **in that** the uncovered parts of the covering layer (5) are removed.

7. Process according to Claim 6, **characterized in that** the parts of the covering layer (5) to be removed are removed during the development of the second radiation-sensitive layer (6) irradiated in accordance with the pattern.

8. Process according to Claim 6 or 7, **characterized in that** the radiation-sensitivity range of the second radiation-sensitive layer (6) is different from that of the first radiation-sensitive layer (4).

9. Process according to one of Claims 6 to 8, **characterized in that** the second radiation-sensitive layer (6) is formed from a photoresist that is sensitive to visible light radiation.

10. Process according to Claim 9, **characterized in that** the photoresist is a positive resist that can be decomposed by light.

11. Process according to one of Claims 6 to 10, **characterized in that** the second radiation-sensitive layer (6) is 1 µm to 20 µm, preferably 7 µm to 14 µm, in particular 10 µm, thick.

12. Process according to one of Claims 6 to 11, **characterized in that** the covering layer (5) also absorbs radiation in the radiation sensitivity range of the second radiation-sensitive layer (4, 6).

13. Process according to one of Claims 6 to 12, **characterized in that**, in order to irradiate the second radiation-sensitive layer (6), a laser light source is used which preferably emits laser light in the visible range, in particular in the blue range.

14. Process according to one of Claims 6 to 13, **characterized in that** the irradiation of the second radiation-sensitive layer (6) in accordance with the pattern is performed point by point.

15. Process according to Claim 14, **characterized in that**, during the point-by-point irradiation a plurality of pattern points located alongside one another are irradiated simultaneously in accordance with the pattern by means of an appropriate number of irradiation points.

16. Process according to one of the preceding claims, **characterized in that** the covering layer (5) contains fine light-absorbing and/or light-reflecting particles, in particular carbon black, or fine metal particles, pigments and/or radiation-absorbing chemicals.

17. Process according to Claim 16, **characterized in that** the radiation-absorbing chemicals or pigments are added to a wax solution, which is applied to the first radiation-sensitive layer (4) in order to construct the covering layer (5).

18. Process according to Claim 16, **characterized in that** the fine light-absorbing or light-reflecting particles are suspended in gelatin or polyvinyl alcohol.

19. Process according to Claim 18, **characterized in that** the suspension of fine metal particles in gelatin is produced by reduction of metal salts, in particular silver halides, dissolved in gelatin.

20. Process according to one of the preceding claims, **characterized in that** the covering layer (5) is applied using an immersion-coating process.

21. Process according to one of the preceding claims, **characterized in that** the covering layer (5) is 1 µm to 20 µm, preferably 7 µm to 14 µm, in particular 10 µm, thick.

22. Process according to one of the preceding claims, **characterized in that** the first radiation-sensitive layer is a photopolymer layer, in particular a photoelastomer layer (4), for example with a thickness of 1 mm to 10 mm, preferably of 2 mm to 5 mm.

23. Process according to one of Claims 1 to 21, **characterized in that** the first radiation-sensitive layer is a photoresist layer (4'), which is preferably applied to the carrier (1, 1') using an immersion-coating process.

24. Process according to Claim 23, **characterized in that** the photoresist layer (4') is formed from gelatin or polyvinyl alcohol, the gelatin or polyvinyl alcohol having a photosensitive tanning agent, for example potassium dichromate, added to it.

25. Process according to Claim 23, **characterized in that** the photoresist layer (4') is formed of synthetic resin, preferably epoxy resin, polyester resin or methyl methacrylate resin.

26. Process according to one of Claims 23, 24 or 25, **characterized in that** the photoresist layer (4') has substances added to it to increase its elasticity, in order to prevent the formation of cracks.

27. Process according to one of the preceding claims, **characterized in that** the carrier (1) has a full-area closed surface, to which the first radiation-sensitive layer (4, 4') is applied.

28. Process according to one of Claims 1 to 26, **characterized in that** the carrier (1') for the first radiation-sensitive layer (4') is a screen.

29. Process according to one of the preceding claims, **characterized in that** the carrier (1, 1') is metallic.

30. Process according to Claim 28, **characterized in that** the carrier (1, 1') is formed from a textile fabric, in particular from a silk gauze fabric, which is preferably reinforced by the deposition of metal, chemically and/or by electroplating.

31. Process according to one of the preceding claims, **characterized in that** the carrier (1, 1') is flat.

32. Process according to one of Claims 1 to 30, **characterized in that** the carrier (1, 1') is cylindrical.

## Revendications

1. Procédé pour fabriquer un cliché d'impression, dans lequel
- sur une première couche (4, 4') sensible au rayonnement, disposée sur un support (1, 1'), est appliquée une couche de couverture (5) étanche au rayonnement et/ou à la lumière,
- sur la couche de couverture (5) est appliquée un masque de structuration (6'), structuré de manière correspondante à un motif souhaité,
- la couche de recouvrement (5) appliquée est structurée de manière correspondante au motif, en utilisant le masque de structuration (6') pour former un masque d'irradiation (5'), et
- la première couche (4) sensible au rayonnement est irradiée et développée.

2. Procédé selon la revendication 1, **caractérisé en ce que** la couche de recouvrement (5) structurée selon le motif, donc le masque d'irradiation (5'), est enlevé lors du développement de la première couche (4) sensible au rayonnement.

3. Procédé selon la revendication 1 ou 2, **caractérisé en ce que** le masque d'irradiation (5') est enlevé par voie mécanique et/ou chimique.

4. Procédé selon l'une des revendications 1 à 3, **caractérisé en ce que** le masque de structuration (6') est appliqué par injection selon le motif sur la couche de recouvrement (5), en particulier est appliqué par injection en mode points, et **en ce que** les parties non couvertes de la couche de recouvrement (5) sont enlevées.

5. Procédé selon la revendication 4, **caractérisé en ce que**, pour appliquer le masque de structuration (6'), on applique par projection, selon le motif, une solution de cire, et **en ce que** les parties non couvertes de la couche de recouvrement sont enlevées par voie chimique, de préférence par gravure.

6. Procédé selon la revendication 1, 2 ou 3, **caractérisé en ce que**, pour appliquer le masque de structuration (6'), sur la couche de recouvrement (5), une deuxième couche (6) sensible au rayonnement est appliquée, irradiée selon le motif et développée, et **en ce que** les parties non couvertes de la couche de recouvrement (5) sont enlevées.

7. Procédé selon la revendication 6, **caractérisé en ce que** les parties à enlever de la couche de recouvrement (5) sont enlevées lors du développement de la deuxième couche (6) sensible au rayonnement, irradiée selon le motif.

8. Procédé selon la revendication 6 ou 7, **caractérisé en ce que** la plage de sensibilité au rayonnement de la deuxième couche (6) sensible au rayonnement est différente de celle de la première couche (4) sensible au rayonnement.

9. Procédé selon l'une des revendications 6 à 8, **caractérisé en ce que** la deuxième couche (6), sensible au rayonnement, est formée par une photo-laque sensible au rayonnement pour la lumière visible.

10. Procédé selon la revendication 9, **caractérisé en ce que** la photo-laque est une laque positive, décomposable par la lumière.

11. Procédé selon l'une des revendications 6 à 10, **caractérisé en ce que** la deuxième couche (6) sensible au rayonnement est d'une épaisseur de 1 µm à 20 µm, de préférence de 7 µm à 14 µm, en particulier de 10 µm.

12. Procédé selon l'une des revendications 6 à 11, **caractérisé en ce que** la couche de recouvrement (5) absorbe également du rayonnement dans la plage de sensibilité au rayonnement de la deuxième couche (4, 6) sensible au rayonnement.

13. Procédé selon l'une des revendications 6 à 12, **caractérisé en ce que**, pour irradier la deuxième couche sensible au rayonnement, on utilise une source de lumière laser, qui émet une lumière laser, de préférence dans la plage visible, en particulier dans la plage des bleus.

14. Procédé selon l'une des revendications 6 à 13, **caractérisé en ce que** l'irradiation selon le motif de la deuxième couche (6) sensible au rayonnement est effectué en mode points.

15. Procédé selon la revendication 14, **caractérisé en ce que**, lors de l'irradiation en mode points, plusieurs points de motifs, situés les uns à côté des autres, sont irradiés selon le motif, simultanément, au moyen d'un nombre correspondant de points d'irradiation.

16. Procédé selon l'une des revendications précédentes, **caractérisé en ce que** la couche de recouvrement (5), contient de fines particules absorbant la lumière et/ou réfléchissant la lumière, en particulier de la suie (noir de carbone) ou de fines particules métalliques, des pigments et/ou des produits chimiques absorbant le rayonnement.

17. Procédé selon la revendication 16, **caractérisé en ce que** les produits chimiques ou les pigments absorbant le rayonnement sont ajoutés à une solution de cire, appliquée pour former la couche de recouvrement (5) sur la première couche (4) sensible au rayonnement.

18. Procédé selon la revendication 16, **caractérisé en ce que** les fines particules, absorbant la lumière ou réfléchissant la lumière, sont mises en suspension dans de la gélatine ou de l'alcool polyvinylique.

19. Procédé selon la revendication 18, **caractérisé en ce que** la suspension de fines particules métalliques dans de la gélatine est produite par réduction de sels métalliques dissous dans de la gélatine, en particulier des halogénures d'argent.

20. Procédé selon l'une des revendications précédentes, **caractérisé en ce que** la couche de recouvrement (5) est appliquée avec un procédé de revêtement par immersion.

21. Procédé selon l'une des revendications précédentes, **caractérisé en ce que** la couche de recouvrement (5) est d'une épaisseur de 1 µm à 20 µm, de préférence de 7 µm à 14 µm, en particulier de 10 µm.

22. Procédé selon l'une des revendications précédentes, **caractérisé en ce que** la première couche sensible au rayonnement est une couche de photopolymère, en particulier une couche de photoélastomère (4), par exemple d'une épaisseur de 1 mm à 10 mm, de préférence de 2 mm à 5 mm.

23. Procédé selon l'une des revendications 1 à 21, **caractérisé en ce que** la première couche sensible au rayonnement est une couche de photo-laque (4') appliquée sur le support (1, 1'), de préférence avec un procédé de revêtement par immersion.

24. Procédé selon la revendication 23, **caractérisé en ce que** la couche de photo-laque (4') est formée de gélatine ou d'alcool polyvinylique, à la gélatine ou à l'alcool polyvinylique étant ajouté un matériel tannant photosensible, par exemple du bichromate de potassium.

25. Procédé selon la revendication 23, **caractérisé en ce que** la couche de photo-vernis (4') est formée de résine synthétique, de préférence de résine époxy, de résine polyester ou de résine de méthylméthacrylate.

26. Procédé selon l'une des revendications 23, 24 ou 25, **caractérisé en ce qu'**à la couche de photo-vernis (4') sont ajoutées des substances pour augmenter son élasticité, afin d'empêcher une formation de fissure.

27. Procédé selon l'une des revendications précédentes, **caractérisé en que** le support (1) présente une surface fermée, faisant toute l'étendue, sur laquelle est appliquée la première couche (4, 4') sensible au rayonnement.

28. Procédé selon l'une des revendications 1 à 26, **caractérisé en ce que** le support (1') pour la première couche (4') sensible au rayonnement est un tamis.

29. Procédé selon l'une des revendications précédentes, **caractérisé en ce que** le support (1, 1') est métallique.

30. Procédé selon la revendication 28, **caractérisé en ce que** le support (1, 1') est formé d'un tissu textile, en particulier d'un tissu de gaze de soie, renforcé de préférence par dépôt métallique effectué par voie chimique et/ou galvanique.

31. Procédé selon l'une des revendications précédentes, **caractérisé en ce que** le support (1, 1') est plat.

32. Procédé selon l'une des revendications 1 à 30, **caractérisé en ce que** le support (1, l') est cylindrique.
